# EUROPÄISCHE PATENTSCHRIFT

(11) **EP 4 345 475 B1**
(45) Veröffentlichungstag und Bekanntmachung des Hinweises auf die Patenterteilung: **06.05.2026**
(21) Anmeldenummer: 22198122.8
(22) Anmeldetag: 27.09.2022
(51) Int. Cl.: G01R 33/34, G01R 33/36, G01R 33/341, G01R 33/3415

(54) **LOKALSPULE FÜR EIN MAGNETRESONANZSYSTEM**
LOCAL COIL FOR A MAGNETIC RESONANCE SYSTEM
BOBINE LOCALE POUR SYSTÈME DE RÉSONANCE MAGNÉTIQUE

(43) Veröffentlichungstag der Anmeldung: 03.04.2024
(73) Patentinhaber: Siemens Healthineers AG, 91301 Forchheim (DE)
(72) Erfinder: Biber, Stephan, 91056 Erlangen (DE)
(74) Vertreter: Siemens Healthineers Patent Attorneys

(56) Entgegenhaltungen:
- WO-A1-2021/219340
- DE-A1- 102007 047 020
- DE-U1- 202015 105 111
- US-A1- 2019 339 345
- AGAZI SAMUEL TESFAI ET AL: "Intra-oral flexible coil for improved visibility of dental root canals in MRI", PROCEEDINGS OF THE 2021 ISMRM & SMRT ANNUAL MEETING & EXHIBITION, 15-20 MAY 2021, ISMRM, 2030 ADDISON STREET, 7TH FLOOR, BERKELEY, CA 94704 USA, no. 3946, 30 April 2021 (2021-04-30), XP040725963

## Beschreibung

Erkrankungen der Zähne und des Zahnhalteapparats, wie z. B. Karies oder Parodontitis, werden heutzutage üblicherweise mit röntgenbasierten Bildgebungsverfahren diagnostiziert. Dabei kommen vor allem konventionelle oder digitale Röntgen-Projektionsverfahren, sowie kürzlich auch dreidimensionale Röntgenverfahren, zum Einsatz. Ein Beispiel für ein dreidimensionales Röntgenverfahren stellt die digitale Volumentomographie dar, welche für eine Bildgebung von Zähnen und des Viscerocraniums eingesetzt werden kann.

Ein großer Nachteil von Röntgenverfahren ist die Notwendigkeit des Einsatzes von ionisierender Strahlung für die Bildgebung. Ein Bildgebungsverfahren, welches ionisierende Strahlen vermeidet, stellt die Magnetresonanztomografie dar. Diese ermöglicht typischerweise einen besseren Weichgewebekontrast als Röntgenverfahren und unterstützt standardmäßig eine dreidimensionale Bildgebung eines Untersuchungsobjekts. Weiterhin ermöglicht die Magnetresonanztomografie eine Bildgebung von Zysten sowie eine Erkennung einer Degradation von Dentin, noch bevor dies durch ein Röntgenverfahren erkennbar wird. Die Magnetresonanztomografie stellt somit eine potenzielle Alternative zu bekannten Röntgenverfahren bei der Bildgebung einer Gebissregion und/oder einer Kieferregion sowie der Diagnose von Zahnerkrankungen des Untersuchungsobjekts dar.

Die Magnetresonanztomografie ist ein bekanntes Bildgebungsverfahren, mit welchem Magnetresonanzbilder eines Inneren des Untersuchungsobjekts erzeugt werden können. Zur Durchführung einer Magnetresonanzbildgebung wird das Untersuchungsobjekt üblicherweise in einem starken, statischen und homogenen Grundmagnetfeld (B0-Magnetfeld) einer Magnetresonanzvorrichtung positioniert. Das Grundmagnetfeld kann magnetische Feldstärken von 0,2 Tesla bis 7 Tesla aufweisen, sodass sich Kernspins des Untersuchungsobjekts entlang des Grundmagnetfeldes ausrichten. Um sogenannte Kernspinresonanzen auszulösen, werden hochfrequente Signale, sogenannte Anregungsimpulse (B1-Magnetfeld), in das Untersuchungsobjekt eingestrahlt. Jeder Anregungsimpuls bewirkt eine Abweichung einer Magnetisierung bestimmter Kernspins des Untersuchungsobjekts von dem Grundmagnetfeld um einen Betrag, welcher auch als Flipwinkel bekannt ist. Ein Anregungsimpuls kann dabei ein magnetisches Wechselfeld mit einer Frequenz aufweisen, welche der Larmorfrequenz bei der jeweiligen statischen Magnetfeldstärke entspricht. Die angeregten Kernspins können eine rotierende und abklingende Magnetisierung (Kernspinresonanz) aufweisen, welche sich mittels spezieller Antennen als Magnetresonanzsignal erfassen lässt. Zur räumlichen Kodierung der Kernspinresonanzen des Untersuchungsobjekts können dem Grundmagnetfeld magnetische Gradientenfelder überlagert werden.

Die empfangenen Magnetresonanzsignale werden typischerweise digitalisiert und als komplexe Werte in einer k-Raum-Matrix gespeichert. Diese k-Raum-Matrix kann als Grundlage für die Rekonstruktion von Magnetresonanzbildern sowie einer Bestimmung von Spektroskopiedaten verwendet werden. Die Rekonstruktion eines Magnetresonanzbilds erfolgt typischerweise mittels einer mehrdimensionalen Fourier-Transformation der k-Raum-Matrix.

Die Magnetresonanztomografie eignet sich aufgrund der Vermeidung von ionisierender Strahlung insbesondere für eine frequente bzw. kontinuierliche diagnostische Überwachung von Zahnerkrankungen und/oder einer Zahnentwicklung. Diagnostisch relevante Bereiche der Kieferregion eines Patienten, wie z. B. eine Mundhöhle, ein Gebiss, ein Zahnbogen oder ein Zahn, stellen jedoch ein geringes Volumen bereit, welches für eine Erzeugung von Magnetresonanzsignalen zur Verfügung steht. Ferner werden konventionelle Volumen- und Oberflächenspulen, wie z. B. Kopfspulen und Auflegespulen, in einem relativ großen Abstand zu dem diagnostisch relevanten Bereich positioniert. Aus den genannten Gründen weisen konventionelle Volumen- und Oberflächenspulen ein relativ niedriges Signal-zu-Rausch-Verhältnis auf, welches bei einer Verwendung von Magnetresonanzvorrichtungen mit niedrigen Feldstärken (z. B. zwischen 0,2 und 0,7 T) nur eine geringe Bildqualität zulässt.

Die Druckschrift DE 20 2015105111 U1 beschreibt eine kabellose HF-Spule für MR-Messungen an ein Zielvolumen in einem oralen Bereich eines zu untersuchenden Objekts, welche zur weiteren Signalverarbeitung mit einer Empfangsspule einer Auswerteeinheit induktiv koppelbar ist.

AGAZI SAMUEL TESFAI et al. ("Intra-oral flexible coil for improved visibility of dental root canals in MRI", PROCEEDINGS OF THE 2021 ISMRM & SMRT ANNUAL MEETING & EXHIBITION, 15-20 MAY 2021, ISMRM, 2030 ADDISON STREET, 7TH FLOOR, BERKELEY, CA 94704 USA, Nr. 3946, 30. April 2021 (2021-04-30), XP040725963) beschreiben eine dünne und flexible, induktiv gekoppelte Intraoralspule, welche an die dentale Anatomie angepasst ist und eine verbesserte Sichtbarkeit der Zahnpulpa und Wurzelkanäle erlaubt.

In der Druckschrift DE 10 2007 047020 A1 wird eine Anordnung zur Übertragung von Magnetresonanzsignalen offenbart, aufweisend eine Lokalspule mit einer Anzahl von Einzelantennen und Vorverstärkern, die zur Verstärkung der hochfrequenten Signale vorgesehen sind, und mit einer Übertragungseinrichtung, die zur Übertagung der hochfrequenten Signale von der Lokalspule zu den Vorverstärkern ausgebildet ist.

Die Druckschrift WO 2021/219340 A1 offenbart eine Antennenanordnung, bestehend aus mindestens einem Signalleiter und einem Trägerelement, das mit der Antennenanordnung verbunden ist. Das Trägerelement ist einem Teil eines Gebisses eines Untersuchungsobjekts nachgeformt und kann in einer Anwendungsposition formschlüssig mit dem Gebiss des Patienten verbunden werden.

Die Druckschrift US 2019/339345 A1 bezieht sich auf eine induktive Speisung einer RF-Spule für die Magnetresonanztomographie sowie ein System mit einer RF-Spule für die Magnetresonanztomographie und einer Speisungsspule zum induktiven Speisen der RF-Spule mit einem RF-Signal.

Es ist daher eine Aufgabe der Erfindung, eine Lokalspule bereitzustellen, welche eine Qualität erfasster Magnetresonanzbildern verbessert.

Diese Aufgabe wird durch den Gegenstand des unabhängigen Patentanspruchs 1 erfindungsgemäß gelöst. Vorteilhafte Ausführungsformen und zweckmäßige Weiterbildungen sind Gegenstand der Unteransprüche.

Die erfindungsgemäße Lokalspule umfasst eine erste Antenneneinheit und eine zweite Antenneneinheit, wobei die erste Antenneneinheit und die zweite Antenneneinheit galvanisch getrennt sind und dazu ausgebildet sind, Magnetresonanzsignale eines Untersuchungsobjekts zu empfangen.

Die erste Antenneneinheit und die zweite Antenneneinheit weisen jeweils ein oder mehrere als Signalleiter ausgestaltete Empfangselemente auf. Ein Empfangselement kann ein Koppelelement zwischen in Signalleitern geführten und ungeführten, d. h. in einem Freiraum befindlichen, elektromagnetischen Wellen darstellen. Das Empfangselement ist vorzugsweise dazu ausgebildet, elektromagnetische Wellen im Bereich einer Magnetresonanzfrequenz eines magnetresonanzaktiven Atomkerns zu empfangen. Als hochfrequentes Signal wird dabei beispielsweise eine elektromagnetische Welle mit einer Frequenz zwischen 1 und 500 MHz, vorzugsweise zwischen 10 und 300 MHz angesehen. Das Magnetresonanzsignal üblicher zu untersuchender Atomkerne kann eine geringe Leistung von einigen Mikrowatt bis mehrere Milliwatt aufweisen.

Ein Signalleiter umfasst vorzugsweise einen elektrisch leitenden Draht. Der Draht des Signalleiters kann einen ovalen oder polygonalen Querschnitt aufweisen, welcher geeignet ist, die oben angegebenen Leistungen dauerhaft zu übertragen. Es ist vorstellbar, dass der Signalleiter als eine Leiterbahn auf einer Leiterplatte der ersten Antenneneinheit und/oder der zweiten Antenneneinheit ausgeführt ist. Der Signalleiter kann aus Kupfer bestehen. Es sind aber auch andere elektrisch leitende Metalle, wie z. B. Gold, Silber oder Aluminium, vorstellbar. Vorzugsweise weist ein Empfangselement zumindest einen Signalleiter auf.

Die erste Antenneneinheit und die zweite Antenneneinheit sind galvanisch voneinander getrennt. Dies kann bedeuten, dass eine galvanische Verbindung oder eine elektrische Verbindung zwischen der ersten Antenneneinheit und der zweiten Antenneneinheit vermieden wird.

Es ist vorstellbar, dass die erste Antenneneinheit und die zweite Antenneneinheit mechanisch miteinander verbunden sind. Eine solche mechanische Verbindung kann mittels einer beliebigen kraftschlüssigen, formschlüssigen und/oder stoffschlüssigen Verbindung bereitgestellt sein. Eine mechanische Verbindung zwischen der ersten Antenneneinheit und der zweiten Antenneneinheit ist vorzugsweise dazu ausgebildet, eine Leitung von elektrischem Strom zwischen der ersten Antenneneinheit und der zweiten Antenneneinheit zu reduzieren oder zu verhindern.

In einer bevorzugten Ausführungsform wird eine mechanische Verbindung zwischen der ersten Antenneneinheit und der zweiten Antenneneinheit vermieden. Dies kann bedeuten, dass die erste Antenneneinheit und die zweite Antenneneinheit mechanisch unverbunden sind. Die erste Antenneneinheit und die zweite Antenneneinheit können bei anwendungsgemäßer Positionierung der Lokalspule an dem Untersuchungsobjekt separat voneinander, z. B. in einem Abstand von wenigen Zentimetern oder wenigen Millimetern, vorliegen.

Bei anwendungsgemäßer Positionierung der Lokalspule relativ zu dem Untersuchungsobjekt umschließt die zweite Antenneneinheit die erste Antenneneinheit zumindest teilweise entlang einer Umfangsrichtung der ersten Antenneneinheit. Dies kann bedeuten, dass eine Projektion der zweiten Antenneneinheit entlang einer Richtung einer Flächennormalen einer Hauptoberfläche der ersten Antenneneinheit die erste Antenneneinheit zumindest teilweise entlang einer Umfangsrichtung umschließt. Es ist ebenso vorstellbar, dass ein Körper der zweiten Antenneneinheit einen Körper der erste Antenneneinheit zumindest teilweise entlang der Umfangsrichtung umschließt.

Die zweite Antenneneinheit kann insbesondere eine gekrümmte oder gebogene Form aufweisen. Es ist vorstellbar, dass eine Projektion einer bei Verbindung zweier Endpunkte der zweiten Antenneneinheit von der zweiten Antenneneinheit umschlossenen Fläche entlang der Richtung der Flächennormalen der Hauptoberfläche der ersten Antenneneinheit eine nichtleere Schnittmenge mit der Hauptoberfläche der ersten Antenneneinheit aufweist oder diese vollständig umschließt.

Eine Umfangsrichtung kann eine beliebige Richtung sein, welche einem Umfang einer Grundform oder einer Grundfläche der ersten Antenneneinheit folgt.

Ein Querschnitt der zweiten Antenneneinheit weist vorzugsweise eine konvex-konkave Gestalt auf. Dies kann bedeuten, dass die zweite Antenneneinheit auf einer von der ersten Antenneneinheit abgewandten Seite eine konvexe Form aufweist, während eine der ersten Antenneneinheit zugewandte Seite der zweiten Antenneneinheit eine konkave Form aufweist. Die erste Antenneneinheit ist bei anwendungsgemäßer Positionierung der Lokalspule relativ zu dem Untersuchungsobjekt vorzugsweise derart positioniert, dass die erste Antenneneinheit von einer Oberfläche der zweiten Antenneneinheit mit der konkaven Form zumindest teilweise umgeben oder umschlossen ist.

Eine Oberflächenkontur der Seite mit der konkaven Form der zweiten Antenneneinheit kann beispielsweise einem Kreisbogen, einem Ellipsenbogen oder einem geöffneten Dreieck (V-Form) sowie einem anderen geöffneten Polygon nachgeformt sein. Gemäß der Erfindung ist bei anwendungsgemäßer Positionierung der Lokalspule relativ zu dem Untersuchungsobjekt die erste Antenneneinheit in einem Inneren des Untersuchungsobjekts und die zweite Antenneneinheit an einer Außenoberfläche des Untersuchungsobjekts angeordnet.

Die erste Antenneneinheit ist dazu ausgebildet, in einem Inneren des Untersuchungsobjekts positioniert zu werden. Dies kann bedeuten, dass die ersten Antenneneinheit Anforderungen hinsichtlich einer Abmessung, eines Berührschutzes und/oder einer Biokompatibilität in Abhängigkeit des Untersuchungsobjekts erfüllt.

Das Untersuchungsobjekt ist ein Patient, insbesondere ein Mensch oder ein Tier. Die erste Antenneneinheit ist bei anwendungsgemäßer Positionierung der Lokalspule intraoral in dem Patienten positioniert. Die zweite Antenneneinheit ist vorzugsweise derart ausgestaltet, dass sie einer Außenoberfläche einer Körperregion des Patienten, welche die ersten Antenneneinheit umgibt oder verdeckt, nachgeformt ist und/oder diese zumindest teilweise umschließt.

In einem Beispiel ist die erste Antenneneinheit einem Zahnbogen eines Patienten nachgeformt. Die erste Antenneneinheit ist bei anwendungsgemäßer Positionierung der Lokalspule relativ zu dem Patienten entlang einer Okklusionsebene zwischen einem oberen Zahnbogen und einem unteren Zahnbogen des Patienten angeordnet, während die zweite Antenneneinheit eine Kieferregion des Patienten entlang einer Außenkontur der Kieferregion zumindest teilweise umschließt.

Vorzugsweise sind die ersten Antenneneinheit und die zweite Antenneneinheit galvanisch und mechanisch unverbunden oder getrennt.

Durch das Vermeiden einer mechanischen und galvanischen Verbindung zwischen der ersten Antenneneinheit und der zweiten Antenneneinheit lässt sich eine Verletzungsgefahr eines Patienten, welche mit einer Positionierung der ersten Antenneneinheit in einen Inneren des Patienten und einem Hinausführen mechanischer und/oder elektrischer Strukturen aus dem Inneren des Patienten einhergeht, auf vorteilhafte Weise vermeiden.

Die zweite Antenneneinheit weist eine induktive Kopplung mit der ersten Antenneneinheit auf, wobei die zweite Antenneneinheit dazu ausgebildet ist, ein von der ersten Antenneneinheit empfangenes Magnetresonanzsignal mittels der induktiven Kopplung zu erfassen.

Die erste Antenneneinheit kann ein Empfangselement oder mehrere Empfangselemente gemäß einer oben beschriebenen Ausführungsform aufweisen. Durch ein Wechselwirken mit angeregten Kernspins können elektrische Ströme bzw. Magnetresonanzsignale in einem Empfangselement der ersten Antenneneinheit induziert werden. Die mittels des Empfangselements der ersten Antenneneinheit empfangenen Magnetresonanzsignale können als elektrische Ströme selbst ein magnetisches Feld generieren, welches einen elektrischen Stromfluss in einem Empfangselement oder mehreren Empfangselementen der zweiten Antenneneinheit verursacht. Die auf diese Weise in der zweiten Antenneneinheit induzierten elektrischen Ströme können mit dem empfangenen Magnetresonanzsignal der ersten Antenneneinheit korreliert sein bzw. mit diesem korrespondieren. Es ist ebenso vorstellbar, dass die auf diese Weise in der zweiten Antenneneinheit induzierten elektrischen Ströme eine Information über das empfangene Magnetresonanzsignal der ersten Antenneneinheit enthalten.

Eine Güte des mittels der induktiven Kopplung erfassten Magnetresonanzsignals (z. B. eine Signalstärke oder ein Signal-zu-Rausch-Verhältnis) und/oder eine Qualität der induktiven Kopplung kann insbesondere von einer relativen Position und/oder Ausrichtung der ersten Antenneneinheit zu der zweiten Antenneneinheit abhängen.

Die zweite Antenneneinheit kann weiterhin dazu ausgebildet sein, Magnetresonanzsignale aus dem Untersuchungsobjekt direkt zu empfangen. Dies kann bedeuten, dass die zweite Antenneneinheit zusätzlich zu den mittels induktiver Kopplung erfassten Magnetresonanzsignalen der ersten Antenneneinheit auch direkt Magnetresonanzsignale des Untersuchungsobjekts erfassen kann.

Es ist vorstellbar, dass die erfindungsgemäße Lokalspule außerdem eine Sendeeinheit umfasst. Die Sendeeinheit kann zumindest ein Sendeelement mit einem Signalleiter aufweisen. Das Sendeelement kann dazu ausgebildet sein, hochfrequente Signale in einem Frequenz- und Leistungsbereich einer Magnetresonanzvorrichtung in das Untersuchungsobjekt auszusenden. Ein mittels der Sendeeinheit ausgesendetes, hochfrequente Signal kann in Abhängigkeit des Grundmagnetfelds der Magnetresonanzvorrichtung beispielsweise in einem Leistungsbereich zwischen wenigen Watt bis mehrere Kilowatt liegen. Der Signalleiter der Sendeeinheit kann beispielsweise mit einem Wechselstrom beaufschlagt werden, um ein hochfrequentes Signal, das sogenannte B1-Magnetfeld, in das Untersuchungsobjekt auszusenden.

Ein Empfangselement und/oder ein Sendeelement der erfindungsgemäßen Lokalspule weist vorzugsweise einen Berührschutz auf, welcher das Untersuchungsobjekt vor Spannungen und/oder Verbrennungen schützt. Der Signalleiter kann hierfür z. B. eine Beschichtung und/oder eine Verkleidung aus Kunststoff aufweisen. Geeignete Kunststoffe stellen beispielsweise Polytetrafluorethylen (PTFE), diverse Polysiloxane oder dergleichen dar.

Die erste Antenneneinheit und/oder die zweite Antenneneinheit können jeweils eine Trägerstruktur aufweisen, welche mechanisch mit einem Empfangselement der ersten Antenneneinheit und/oder der zweiten Antenneneinheit verbunden ist. Beispielsweise können ein oder mehrere Empfangselemente in die Trägerstruktur eingebettet, eingehängt, eingeklemmt oder eingesteckt sein und/oder mit dieser verklebt oder verschweißt sein. Eine Trägerstruktur kann eine Strukturstabilität oder eine Formstabilität eines Empfangselements oder mehrerer Empfangselemente auf vorteilhafte Weise erhöhen.

Geeignete Materialien für die Trägerstruktur sind z. B. Polykarbonate, glasfaserverstärkte Kunststoffe, Polyethylen, Polytetrafluorethylen, Polymethylmethacrylat oder vergleichbare Kunststoffe. Es ist jedoch ebenso vorstellbar, dass die Trägerstruktur aus einem Naturstoff, wie z. B. Kautschuk oder Naturfaserstoffe, aber auch einer Keramik besteht.

Vorzugsweise ist die Trägerstruktur der zweiten Antenneneinheit zumindest einem Teil einer Außenkontur des Untersuchungsobjekts, wie z. B. einer Kieferregion eines Patienten, nachgeformt. Es ist vorstellbar, dass die Trägerstruktur zumindest einem Teil einer Außenkontur des Untersuchungsobjekts, wie z. B. einer Kieferregion, einer Mund-/Nasenregion und/oder einer Kinnregion eines Patienten, nachgeformt ist. Dabei kann die zweite Antenneneinheit das Untersuchungsobjekt entlang der Außenkontur zumindest teilweise umschließen oder umranden. Insbesondere lässt sich durch das Bereitstellen einer der Außenkontur des Untersuchungsobjekts nachgeformten zweiten Antenneneinheit ein enges Anliegen der zweiten Antenneneinheit an dem Untersuchungsobjekt entlang der Außenkontur sicherstellen.

Dadurch lässt sich ein mittlerer Abstand zwischen der zweiten Antenneneinheit und der Außenkontur des Untersuchungsobjekts und/oder der ersten Antenneneinheit auf vorteilhafte Weise reduzieren. Weiterhin kann durch einen geringen Abstand der zweiten Antenneneinheit zu der Außenkontur des Untersuchungsobjekts und/oder der ersten Antenneneinheit vorteilhaft ein besonders hohes Signal-zu-Rausch-Verhältnis von empfangenen Magnetresonanzsignalen erreicht werden.

Vorzugsweise ist die zweite Antenneneinheit zur Übertragung von Signalen elektrisch mit einer Magnetresonanzvorrichtung verbunden. Es ist vorstellbar, dass die elektrische Verbindung zwischen der zweiten Antenneneinheit und der Magnetresonanzvorrichtung mittels einer elektrischen Anschlussleitung erfolgt. Eine solche elektrische Anschlussleitung kann z. B. ein Koaxialkabel sein, welches eine Abschirmung aufweist, um elektromagnetische Einstreuung aus der Umgebung zu vermeiden.

Die erste Antenneneinheit ist vorzugsweise galvanisch von der Magnetresonanzvorrichtung getrennt. Dies kann bedeuten, dass eine elektrische und/oder galvanische Verbindung zwischen einem Empfangselement der ersten Antenneneinheit und der Magnetresonanzvorrichtung vermieden wird. Dies kann insbesondere bedeuten, dass ein Signal oder ein Magnetresonanzsignal der ersten Antenneneinheit ausschließlich mittels der induktiven Kopplung mit der zweiten Antenneneinheit für eine Magnetresonanzvorrichtung bereitgestellt wird.

Es ist ebenso vorstellbar, dass die erste Antenneneinheit mechanisch von der Magnetresonanzvorrichtung und/oder der zweiten Antenneneinheit getrennt ist.

In einer Ausführungsform weisen die erste Antenneneinheit und/oder die zweite Antenneneinheit eine elektronische Schaltung auf, welche mit einem Signalleiter verbunden ist. Die elektronische Schaltung kann ein elektronisches Bauelement oder einen Zusammenschluss von mehreren elektronischen Bauelementen, wie z. B. Transistoren, Widerständen, Kondensatoren, Dioden, Leiterbahnen und dergleichen, umfassen. Die elektronische Schaltung kann insbesondere eine Schutzschaltung aufweisen, welche dazu geeignet ist, einen Signalleiter gegen eine Überlastung zu schützen. Für die Vermeidung magnetischer Anziehungskräfte, stehender Wellen, Aufheizung und vergleichbarer, unerwünschter Effekte, kann die elektronische Schaltung einen hohen Anteil nicht-magnetischer Materialien sowie entsprechende Mantelwellensperren und/oder Baluns aufweisen. Die elektronische Schaltung weist vorzugsweise eine Leiterplatte (PCB) oder ein vergleichbares Substrat auf, welches dazu geeignet ist, die elektronischen Bauelemente in einer vorbestimmten Position zueinander aufzunehmen.

Durch eine induktive Kopplung der ersten Antenneneinheit und der zweiten Antenneneinheit gemäß der Erfindung lässt sich auf vorteilhafte Weise eine größere Abdeckung eines Volumens des Untersuchungsobjekts, insbesondere eines Volumens im Inneren des Untersuchungsobjekts, bei einer Magnetresonanzuntersuchung erreichen.

Vorzugsweise werden die mittels der ersten Antenneneinheit empfangenen Magnetresonanzsignale ausschließlich mittels der induktiven Kopplung an die zweite Antenneneinheit und/oder eine Magnetresonanzvorrichtung übertragen.

Weiterhin kann eine Vermeidung einer galvanischen und/oder mechanischen Verbindung zwischen der ersten Antenneneinheit und der zweiten Antenneneinheit einen Aufbau der Lokalspule vorteilhaft vereinfachen. Dadurch lassen sich mit der Lokalspule assoziierte Kosten und/oder Fertigungsaufwände reduzieren.

Ferner kann eine Qualität aufgenommener Magnetresonanzbilder durch eine anwendungsgemäße Positionierung der ersten Antenneneinheit in direkter Nähe zu einer diagnostisch relevanten Struktur im Inneren des Untersuchungsobjekts, wie z. B. einer Zahnwurzel, einem Zahnfleisch oder dergleichen, auf vorteilhafte Weise verbessert werden.

In einer Ausführungsform weist die erfindungsgemäße Lokalspule ein Halteelement auf. Das Halteelement ist dazu ausgebildet, die zweite Antenneneinheit in einer vorbestimmten relativen Position zu der ersten Antenneneinheit an der Außenoberfläche des Untersuchungsobjekts zu halten.

Ein Halteelement stellt vorzugsweise einen rigiden Halteapparat für die zweite Antenneneinheit bereit. Das Halteelement kann insbesondere mechanisch mit der zweiten Antenneneinheit und/oder einem Empfangselement der zweiten Antenneneinheit verbunden sein. Die mechanische Verbindung zwischen dem Halteelement und der zweiten Antenneneinheit kann eine beliebige formschlüssige, kraftschlüssige und/oder stoffschlüssige Verbindung umfassen. Es ist vorstellbar, dass die zweite Antenneneinheit mit dem Halteelement verklebt und/oder verschraubt ist. Die zweite Antenneneinheit und das Halteelement können aber auch einstückig ausgeführt sein.

Das Halteelement ist insbesondere dazu ausgebildet, die zweite Antenneneinheit in einer vorbestimmten Relativposition zu der ersten Antenneneinheit zu halten. Eine vorbestimmte Relativposition zwischen der ersten Antenneneinheit und der zweiten Antenneneinheit kann durch eine relative Orientierung und/oder eine relative Position der ersten Antenneneinheit zu der zweiten Antenneneinheit charakterisiert sein, welche eine ausreichende induktive Kopplung zwischen der ersten Antenneneinheit und der zweiten Antenneneinheit ermöglicht.

Durch das Bereitstellen des Halteelements lässt sich die zweite Antenneneinheit, insbesondere ein Empfangselement der zweiten Antenneneinheit, auf vorteilhafte Weise in einer vorbestimmten relativen Position zu der ersten Antenneneinheit fixieren oder befestigen.

In einer Ausführungsform der erfindungsgemäßen Lokalspule ist das Halteelement dazu ausgebildet, die zweite Antenneneinheit bei anwendungsgemäßer Positionierung der Lokalspule relativ zu dem Untersuchungsobjekt derart an der Außenoberfläche des Untersuchungsobjekts zu halten, dass eine Flächennormale einer Hauptoberfläche der ersten Antenneneinheit im Wesentlichen orthogonal zu einer Flächennormalen einer Hauptoberfläche der zweiten Antenneneinheit ausgerichtet ist.

Eine Hauptoberfläche kann eine Seite oder eine Oberfläche mit einem maßgeblichen Flächeninhalt darstellen.

Eine Hauptoberfläche der zweiten Antenneneinheit ist vorzugsweise eine Seite oder Oberfläche der zweiten Antenneneinheit, welche dem Untersuchungsobjekt bei anwendungsgemäßer Positionierung der Lokalspule zugewandt ist.

Die erste Antenneneinheit weist erfindungsgemäß eine im Wesentlichen planare Gestalt auf. Die Hauptoberfläche der ersten Antenneneinheit ist vorzugsweise durch eine Seite oder Oberfläche der ersten Antenneneinheit definiert, welche parallel zu der planaren Gestalt der ersten Antenneneinheit ausgerichtet ist.

Vorzugsweise sind die erste Antenneneinheit und die zweite Antenneneinheit bei anwendungsgemäßer Positionierung der Lokalspule relativ zu dem Untersuchungsobjekt derart zueinander ausgerichtet, dass die Flächennormale der Hauptoberfläche der ersten Antenneneinheit im Wesentlichen orthogonal zu der Flächennormalen der Hauptoberfläche der zweiten Antenneneinheit ausgerichtet ist.

Geringe Abweichungen eines Winkels zwischen der Flächennormale der Hauptoberfläche der ersten Antenneneinheit und der Flächennormalen der Hauptoberfläche der zweiten Antenneneinheit von einer orthogonalen Ausrichtung sind dabei jedoch tolerierbar. Beispielsweise kann der Winkel zwischen der Flächennormale der Hauptoberfläche der ersten Antenneneinheit und der Flächennormalen der Hauptoberfläche der zweiten Antenneneinheit in einem Bereich zwischen 85° und 95°, 80° und 100°, 70° und 110° oder 60° und 120° liegen.

Das Halteelement weist vorzugsweise eine Positionierungseinheit auf, welche dazu ausgebildet ist, eine Position und/oder eine Ausrichtung eines Empfangselements der zweiten Antenneneinheit relativ zu dem Untersuchungsobjekt und/oder der ersten Antenneneinheit einzustellen. Dadurch lässt sich der Winkel zwischen der Flächennormale der Hauptoberfläche der ersten Antenneneinheit und der Flächennormalen der Hauptoberfläche der zweiten Antenneneinheit und somit die Qualität der induktiven Kopplung auf vorteilhafte Weise in Abhängigkeit einer Geometrie des Untersuchungsobjekts einstellen.

Die Positionierungseinheit kann beispielsweise als eine Schiene, ein Scharnier oder ein Gelenk ausgestaltet sein.

Gemäß einer weiteren Ausführungsform der Lokalspule ist das Halteelement dazu ausgebildet, die zweite Antenneneinheit derart an der Außenoberfläche des Untersuchungsobjekts zu halten, dass ein geometrischer Mittelpunkt der ersten Antenneneinheit in einem Schnittpunkt einer Flächennormalen der Hauptoberfläche der zweiten Antenneneinheit mit einer Flächennormalen der Hauptoberfläche der ersten Antenneneinheit angeordnet ist.

Durch eine erfindungsgemäße Ausrichtung der ersten Antenneneinheit und der zweiten Antenneneinheit bei anwendungsgemäßer Positionierung der Lokalspule relativ zu dem Untersuchungsobjekt lässt sich die induktive Kopplung der ersten Antenneneinheit und der zweiten Antenneneinheit auf vorteilhafte Weise verbessern oder optimieren.

In einer bevorzugten Ausführungsform der erfindungsgemäßen Lokalspule ist die zweite Antenneneinheit einem Hohlzylindersektor nachgeformt und umschließt das Untersuchungsobjekt bei anwendungsgemäßer Positionierung der Lokalspule relativ zu dem Untersuchungsobjekt zumindest teilweise entlang einer Außenkontur des Untersuchungsobjekts.

Die zweite Antenneneinheit kann gemäß einer oben beschriebenen Ausführungsform ausgestaltet sein. Der Hohlzylindersektor kann beispielsweise eine C-förmige, eine U-förmige oder eine annähernd V-förmige Grundform bzw. Grundfläche aufweisen. Es ist insbesondere vorstellbar, dass eine bei anwendungsgemäßer Positionierung der Lokalspule der ersten Antenneneinheit zugewandte Seite der zweiten Antenneneinheit im Querschnitt einem Abschnitt eines Kreisbogens, eines Ellipsenbogens oder einer Außenkontur eines Polygons folgt.

Eine Außenkontur des Untersuchungsobjekts ist vorzugsweise durch ein zweidimensionales oder dreidimensionales Profil der Außenoberfläche des Untersuchungsobjekts charakterisiert. Beispielsweise kann die Außenoberfläche des Untersuchungsobjekts durch eine Hautoberfläche eines Patienten, insbesondere eine Hautoberfläche einer Kieferregion, definiert sein. Durch das Bereitstellen einer zweiten Antenneneinheit in Form eines Hohlzylindersektors lässt sich ein mittlerer Abstand zwischen der zweiten Antenneneinheit und der Außenoberfläche des Untersuchungsobjekts und/oder der ersten Antenneneinheit bei Untersuchungsobjekten mit gekrümmten Oberflächen oder Außenkonturen auf vorteilhafte Weise reduzieren oder minimieren.

Erfindungsgemäß weist die erste Antenneneinheit der erfindungsgemäßen Lokalspule eine im Wesentlichen planare Gestalt auf, wobei in einer Ausführungsform ein Empfangselement der ersten Antenneneinheit in einer Ebene angeordnet ist, welche die erste Antenneneinheit schneidet und parallel zu einer Hauptoberfläche der ersten Antenneneinheit ausgerichtet ist, wobei ein geometrischer Mittelpunkt der zweiten Antenneneinheit bei anwendungsgemäßer Positionierung der Lokalspule relativ zu dem Untersuchungsobjekt in der Ebene des Empfangselements der ersten Antenneneinheit liegt.

Vorzugsweise weist die zweite Antenneneinheit ein Halteelement gemäß einer oben beschriebenen Ausführungsform auf. Das Haltelement kann dazu ausgebildet sein, die zweite Antenneneinheit derart an der Außenoberfläche des Untersuchungsobjekts zu halten, dass der geometrische Mittelpunkt der zweiten Antenneneinheit in der Ebene des Empfangselements der ersten Antenneneinheit liegt. Das Halteelement kann weiterhin eine Positionierungseinheit umfassen, welche dazu ausgebildet ist, eine Position und/oder eine Ausrichtung der zweiten Antenneneinheit relativ zu dem Untersuchungsobjekt und/oder der ersten Antenneneinheit einzustellen, sodass der geometrische Mittelpunkt der zweiten Antenneneinheit in der Ebene des Empfangselements der ersten Antenneneinheit liegt.

Es ist ebenso vorstellbar, dass ein Flächenschwerpunkt der zweiten Antenneneinheit in der Ebene des Empfangselements der ersten Antenneneinheit liegt.

Durch eine erfindungsgemäße Ausrichtung der ersten Antenneneinheit und der zweiten Antenneneinheit bei anwendungsgemäßer Positionierung der Lokalspule relativ zu dem Untersuchungsobjekt lässt sich die induktive Kopplung der ersten Antenneneinheit und der zweiten Antenneneinheit auf vorteilhafte Weise weiter verbessern oder optimieren.

In einer Variante der erfindungsgemäßen Lokalspule weist die zweite Antenneneinheit zumindest ein Empfangselement auf, wobei das zumindest eine Empfangselement als eine Butterfly-Spule ausgestaltet ist.

Eine Butterfly-Spule kann durch die Form einer Lemniskate charakterisiert sein. Beispielweise kann sich ein Signalleiter des zumindest einen Empfangselements an einem Kreuzungspunkt selbst überlagern, sodass der Signalleiter zwei Schlaufen ausbildet, die sich am Kreuzungspunkt gegenüberliegen.

Bei dieser erfindungsgemäßen Variante ist ein Kreuzungspunkt der Butterfly-Spule in einer Ebene mit der ersten Antenneneinheit angeordnet. Es ist weiterhin vorstellbar, dass der Kreuzungspunkt mit dem geometrischen Mittelpunkt und/oder dem Flächenschwerpunkt der zweiten Antenneneinheit korrespondiert.

Durch das Bereitstellen einer zweiten Antenneneinheit mit einer Butterfly-Spule kann auf vorteilhafte Weise eine verbesserte oder optimierte induktive Kopplung der zweiten Antenneneinheit mit der ersten Antenneneinheit erreicht werden. Insbesondere kann eine Durchdringung der zweiten Antenneneinheit durch ein von der ersten Antenneneinheit erzeugtes Magnetfeld gegenüber alternativen Anordnungen von Empfangselementen verbessert werden.

Gemäß einer weiteren Variante der erfindungsgemäßen Lokalspule weist die zweite Antenneneinheit zumindest zwei Empfangselemente auf, welche entlang einer Oberflächenkontur der zweiten Antenneneinheit nebeneinander angeordnet sind oder sich zumindest teilweise überlagern.

Die zumindest zwei Empfangselemente der zweiten Antenneneinheit definieren bei dieser erfindungsgemäßen Variante eine Symmetrieebene oder eine Schnittgerade, welche im Wesentlichen parallel zu der Hauptoberfläche der ersten Antenneneinheit ausgerichtet ist. Eine Schnittgerade kann eine Gerade darstellen, welche durch Kreuzungspunkte von Signalleitern zweier sich überlagernder Empfangselemente definiert ist. Eine Symmetrieebene kann eine Ebene darstellen, an welcher sich die zumindest zwei Empfangselemente spiegelsymmetrisch gegenüberliegen.

Vorzugsweise sind die zumindest zwei Empfangselemente derart entlang der Oberflächenkontur der zweiten Antenneneinheit angeordnet, dass die Symmetrieebene oder die Schnittgerade der zumindest zwei Empfangselemente parallel zu der Ebene der Empfangsspule der ersten Antenneneinheit angeordnet ist und/oder mit dieser zusammenfällt.

Die zumindest zwei Empfangselemente der zweiten Antenneneinheit sind dazu ausgebildet, unabhängig voneinander ausgelesen zu werden. Die zumindest zwei Empfangselemente der zweiten Antenneneinheit können voneinander beabstandet sein. Es ist ebenso vorstellbar, dass die zumindest zwei Empfangselemente galvanisch voneinander getrennt sind.

In einer weiteren Ausführungsform sind die zumindest zwei Empfangsspulen durch eine Überlagerung oder Kreuzung von Signalleitern oder kapazitiv entkoppelt.

Durch das Bereitstellen von zumindest zwei Empfangselementen lässt sich eine Abhängigkeit zwischen der Qualität der induktiven Kopplung und einer Relativposition oder einer relativen Anordnung der zweiten Antenneneinheit und der ersten Antenneneinheit auf vorteilhafte Weise reduzieren.

Weiterhin kann eine Geometrie der zweiten Antenneneinheit bei Vorliegen von zumindest zwei Empfangselementen verbessert an eine Außenkontur des Untersuchungsobjekts angepasst werden.

Gemäß einer weiteren Ausführungsform der erfindungsgemäßen Lokalspule weist die zweite Antenneneinheit zumindest drei Empfangselemente auf.

Vorzugsweise ist wenigstens ein Empfangselement der zumindest drei Empfangselemente als eine Butterfly-Spule ausgestaltet. Es ist jedoch ebenso vorstellbar, dass wenigstens ein Empfangselement einen Signalleiter aufweist, welcher eine ovale oder polygonale Form oder Grundfläche aufweist.

Die zumindest drei Empfangselemente sind entlang einer Oberflächenkontur der zweiten Antenneneinheit nebeneinander angeordnet oder überlagern sich zumindest teilweise.

Vorzugsweise sind die zumindest drei Empfangselemente bei anwendungsgemäßer Positionierung der Lokalspule relativ zu dem Untersuchungsobjekt einer üblichen X-Richtung einer Magnetresonanzvorrichtung folgend nebeneinander oder teilweise überlagernd entlang der Oberflächenkontur der zweiten Antenneneinheit (oder der Trägerstruktur) angeordnet.

Es ist insbesondere vorstellbar, dass die zumindest drei Empfangselemente bei anwendungsgemäßer Positionierung der Lokalspule relativ zu einem Patienten nebeneinander oder teilweise überlappend entlang einer Transversalebene des Patienten angeordnet sind.

In einem Beispiel kann die zweite Antenneneinheit in einem flach ausgelegten oder ausgebreiteten Zustand im Wesentlichen die Form eines flachen Quaders mit einer rechteckigen Grundform aufweisen. Es ist jedoch ebenso vorstellbar, dass die zweite Antenneneinheit einen von einem Rechteck abweichenden Querschnitt aufweist. Beispielsweise kann die zweiten Antenneneinheit eine V-förmige Grundfläche (z. B. eine rechteckige Grundform mit einem Knick oder einer Biegung) aufweisen, um ein Nachformen oder ein Anlegen der zweiten Antenneneinheit an ein Untersuchungsobjekt mit einer gekrümmten Außenoberfläche, insbesondere eine Kopfregion oder Kieferregion eines Patienten, zu verbessern oder zu vereinfachen. Die zumindest drei Empfangselemente der Antenneneinheit sind vorzugsweise derart angeordnet, dass sie nebeneinander oder teilweise überlappend der Grundform (z. B. Rechteck oder V-form) der zweiten Antenneneinheit in einem ausgebreiteten Zustand folgen. Es ist insbesondere vorstellbar, dass geometrische Mittelpunkte der zumindest drei Empfangselemente einer üblichen X-Richtung einer Magnetresonanzvorrichtung folgend nebeneinander oder teilweise überlappend entlang einer Oberfläche oder Außenkontur der zweiten Antenneneinheit und/oder der Trägerstruktur angeordnet sind.

Ein teilweises Überlagern von zwei Empfangselementen kann bedeuten, dass zwei Empfangselemente derart überlappen, dass ein Anteil von mehr als 5%, mehr als 10%, mehr als 15% oder mehr als 20% einer umschlossenen Grundfläche eines ersten Empfangselements von einem zweiten Empfangselement überdeckt wird.

In einer Ausführungsform der erfindungsgemäßen Lokalspule weist die zweite Antenneneinheit zumindest fünf Empfangselemente oder zumindest sieben Empfangselemente auf, welche entlang der Oberflächenkontur der zweiten Antenneneinheit nebeneinander angeordnet sind oder sich zumindest teilweise überlagern.

In einer bevorzugten Ausführungsform sind die zumindest drei Empfangselemente dazu ausgebildet, unabhängig voneinander ausgelesen zu werden.

Durch das Bereitstellen einer zweiten Antenneneinheit mit zumindest drei Empfangselementen lässt sich die induktive Kopplung zwischen der ersten Antenneneinheit und der zweiten Antenneneinheit vorteilhaft verbessern oder optimieren.

Erfindungsgemäß ist das Untersuchungsobjekt eine Kieferregion eines Patienten. Erfindungsgemäß ist bei anwendungsgemäßer Positionierung der Lokalspule relativ zu der Kieferregion die erste Antenneneinheit entlang einer Okklusionsebene in einer Mundhöhle des Patienten angeordnet.

Erfindungsgemäß weist die erste Antenneneinheit eine im Wesentlichen planare Gestalt, vorzugsweise mit einer U-förmigen oder C-förmigen Grundfläche auf. Beispielsweise kann die erste Antenneneinheit einem Zahnbogen des Patienten nachgeformt sein. Die erste Antenneneinheit kann insbesondere derart ausgestaltet sein, dass eine Oberfläche und/oder Grundfläche der ersten Antenneneinheit im Wesentlichen mit einer von einem Zahnbogen gebildete Oberfläche entlang der Okklusionsebene übereinstimmt. Die erste Antenneneinheit kann aber auch etwas, z. B. wenige hundertstel Millimeter oder wenige Millimeter, über eine Oberfläche des Zahnbogens entlang der Okklusionsebene überstehen.

Die zweite Antenneneinheit ist einer Außenkontur der Kieferregion des Patienten nachgeformt und umschließt die Kieferregion entlang der Außenkontur zumindest teilweise.

Die zweite Antenneneinheit, aber auch die Trägerstruktur, können der Kieferregion des Patienten gemäß einer oben beschriebenen Ausführungsform nachgeformt sein und diese zumindest teilweise entlang einer Außenkontur umschließen.

Mittels der erfindungsgemäßen Lokalspule lässt sich eine Abdeckung eines Volumens der Kieferregion des Patienten mit Empfangselementen auf vorteilhafte Weise gegenüber rein intraoralen Lokalspulen, aber auch Volumen- oder Oberflächenspulen, erhöhen. Dadurch lassen sich Magnetresonanzbilder von Teilen der Kieferregion, aber auch der gesamten Kieferregion, mit einer höheren Qualität bereitstellen.

Ferner lässt sich ein Signal-zu-Rausch-Verhältnis von empfangenen Magnetresonanzsignalen durch einen geringen Abstand zwischen Empfangselementen der erfindungsgemäßen Lokalspule und anatomischen Strukturen der Kieferregion, wie z. B. den Zähnen, dem Zahnfleisch, dem Gaumen, den Kieferknochen, dem Kiefergelenk und dergleichen, auf vorteilhafte Weise erhöhen.

In einer Ausführungsform der erfindungsgemäßen Lokalspule sind geometrische Mittelpunkte von zumindest zwei Empfangselementen der zweiten Antenneneinheit entlang einer Sagittalebene des Patienten angeordnet. Die zumindest zwei Empfangselemente sind nebeneinander angeordnet oder überlagern sich zumindest teilweise.

Die Sagittalebene des Patienten kann bei anwendungsgemäßer Positionierung des Patienten in einer Magnetresonanzvorrichtung parallel zu einer Richtung eines Hauptmagnetfelds der Magnetresonanzvorrichtung und/oder einer Z-Richtung der Magnetresonanzvorrichtung ausgerichtet sein. Vorzugsweise sind die geometrischen Mittelpunkte der zumindest zwei Empfangselemente entlang derselben Sagittalebene des Patienten angeordnet.

Ein geometrischer Mittelpunkt eines Empfangselements kann beispielsweise ein Kreuzungspunkt einer Butterfly-Spule, aber auch ein Mittelpunkt oder eine Rotationsachse eines Empfangselements mit einer ovalen oder polygonalen Grundfläche darstellen.

Vorzugsweise ist zumindest ein Empfangselement der zumindest zwei Empfangselemente als eine Butterfly-Spule ausgestaltet. Die beiden Schlaufen des Signalleiters der Butterfly-Spule sind dabei vorzugsweise im Wesentlichen parallel zu der Sagittalebene des Patienten angeordnet. Dies kann bedeuten, dass geometrische Mittelpunkte der beiden Schlaufen entlang derselben Sagittalebene des Patienten angeordnet sind.

In einer Ausführungsform der erfindungsgemäßen Lokalspule sind geometrische Mittelpunkte von zumindest drei Empfangselementen der zweiten Antenneneinheit entlang einer Transversalebene des Patienten angeordnet. Erfindungsgemäß sind die zumindest drei Empfangselemente nebeneinander angeordnet oder überlagern sich teilweise.

Vorzugsweise sind die geometrischen Mittelpunkte der zumindest drei Empfangsspulen entlang derselben Transversalebene des Patienten angeordnet.

Vorzugsweise ist die Transversalebene, auf welcher geometrische Mittelpunkte von zumindest zwei Empfangselementen oder von zumindest drei Empfangselementen angeordnet sind, bei anwendungsgemäßer Positionierung der Lokalspule relativ zu dem Patienten in einem vorbestimmten Abstand oberhalb und/oder unterhalb der Okklusionsebene des Patienten oder einer Ebene, welche die erste Antenneneinheit schneidet und parallel zu einer Hauptoberfläche der ersten Antenneneinheit ausgerichtet ist, angeordnet. Der vorbestimmte Abstand kann dabei derart ausgelegt sein, dass ein Schneiden von Signalleitern der zumindest zwei Empfangselemente mit der Okklusionsebene des Patienten oder der Ebene, welche die erste Antenneneinheit schneidet und parallel zu der Hauptoberfläche der ersten Antenneneinheit ausgerichtet ist, vermieden wird. Eine solche Anordnung wird insbesondere bei Empfangselementen bevorzugt, welche eine ovale oder polygonale Anordnung des Signalleiters aufweisen.

Geometrische Mittelpunkte oder Kreuzungspunkte von Butterfly-Spulen sind dagegen bevorzugt auf einer Transversalebene angeordnet, welche mit der Okklusionsebene des Patienten oder der Ebene, welche die erste Antenneneinheit schneidet und parallel zu der Hauptoberfläche der ersten Antenneneinheit ausgerichtet ist, zusammenfällt.

Es ist vorstellbar, dass die zumindest drei Empfangsspulen versetzt entlang einer üblichen Y-Richtung der Magnetresonanzvorrichtung nebeneinander angeordnet sind.

Durch eine erhöhte Anzahl von entlang der Transversalebene versetzt angeordneten Empfangselementen lassen sich auf vorteilhafte Weise Magnetresonanzsignale der gesamten Kieferregion, insbesondere auch eines oder beider Kiefergelenke, erfassen.

In einer Ausführungsform sind geometrische Mittelpunkte von zumindest zwei Empfangselementen der zweiten Antenneneinheit entlang einer Geraden angeordnet, welche parallel zu einer Hauptoberfläche der ersten Antenneneinheit und/oder einer Okklusionsebene des Patienten ausgerichtet ist.

Vorzugsweise ist die Hauptoberfläche der ersten Antenneneinheit bei anwendungsgemäßer Positionierung der Lokalspule relativ zu dem Patienten im Wesentlichen parallel zu einer Transversalebene des Patienten ausgerichtet. Es ist ebenso vorstellbar, dass auch die Okklusionsebene des Patienten parallel zu der Transversalebene orientiert ist.

In einer besonders bevorzugten Ausführungsform weist die zweite Antenneneinheit der erfindungsgemäßen Lokalspule zumindest drei Empfangselemente oder zumindest fünf Empfangselemente auf, deren geometrische Mittelpunkte entlang der Transversalebene des Patienten angeordnet sind.

Die geometrischen Mittelpunkte der zumindest zwei Empfangselemente, der zumindest drei Empfangselemente oder der zumindest fünf Empfangselemente können dabei nebeneinander entlang einer Richtung angeordnet sein, welche parallel zu der Hauptoberfläche der ersten Antenneneinheit und/oder der Okklusionsebene des Patienten orientiert ist.

Bei einer erfindungsgemäßen Variante ist zumindest ein Empfangselement der zweiten Antenneneinheit als eine Butterfly-Spule ausgestaltet. In einer besonders bevorzugten Ausführungsform der Lokalspule, ist die zumindest eine Butterfly-Spule entlang eines Abschnitts der Sagittalebene des Patienten und/oder entlang der Z-Richtung der Magnetresonanzvorrichtung von zwei Empfangselementen flankiert. Die zwei Empfangselemente, welche die Butterfly-Spule flankieren, weisen vorzugsweise einen einzigen oval oder polygonal angeordneten Signalleiter auf.

In einer Ausführungsform der erfindungsgemäßen Lokalspule sind die zumindest zwei entlang der Sagittalebene angeordneten Empfangselemente der zweiten Antenneneinheit bei anwendungsgemäßer Positionierung der Lokalspule relativ zu dem Patienten in Y-Richtung der Magnetresonanzvorrichtung jeweils von zumindest einem Empfangselement flankiert.

Durch das Bereitstellen einer erfindungsgemäßen zweiten Antenneneinheit lässt sich die induktive Kopplung zwischen der zweiten Antenneneinheit und der ersten Antenneneinheit auf vorteilhafte Weise verbessern oder optimieren.

Die erfindungsgemäße Magnetresonanzvorrichtung weist eine Lokalspule gemäß einer oben beschriebenen Ausführungsform auf. Die Magnetresonanzvorrichtung ist dazu ausgebildet, von der ersten Antenneneinheit empfangene Magnetresonanzsignale des Untersuchungsobjekts mittels der induktiven Kopplung mit der zweiten Antenneneinheit zu erfassen.

Vorzugsweise ist die zweite Antenneneinheit der Lokalspule ebenfalls dazu ausgebildet, direkt Magnetresonanzsignale des Untersuchungsobjekts zu empfangen. Es ist vorstellbar, dass sich mittels der zweiten Antenneneinheit direkt empfangene Magnetresonanzsignale des Untersuchungsobjekts mit den von der ersten Antenneneinheit mittels der induktiven Kopplung erfassten Magnetresonanzsignalen als elektrische Ströme in einem Empfangselement der zweiten Antenneneinheit zumindest teilweise überlagern.

Die zweite Antenneneinheit weist vorzugsweise eine elektrische Verbindung mit einer Recheneinheit und/oder einer Steuereinheit auf. Die Recheneinheit und/oder Steuereinheit der Magnetresonanzvorrichtung sind vorzugsweise dazu ausgebildet, in Abhängigkeit von Signalen der zweiten Antenneneinheit Magnetresonanzbilder des Untersuchungsobjekts zu erstellen.

Beispielsweise weist die erfindungsgemäße Magnetresonanzvorrichtung zumindest eine elektrische Anschlussleitung auf, welche dazu ausgelegt ist, die zweite Antenneneinheit elektrisch mit der Magnetresonanzvorrichtung zu verbinden.

Eine elektrische oder galvanische Verbindung zwischen der ersten Antenneneinheit und der Magnetresonanzvorrichtung wird vorzugsweise vermieden. Dies kann bedeuten, dass die mittels der ersten Antenneneinheit empfangenen Magnetresonanzsignale ausschließlich mittels der induktiven Kopplung mit der zweiten Antenneneinheit an die Magnetresonanzvorrichtung übertragen werden.

In einer Ausführungsform ist eine Sendeeinheit der Lokalspule mittels einer elektrischen Anschlussleitung mit einer Hochfrequenzeinheit der Magnetresonanzvorrichtung verbunden. Die Hochfrequenzeinheit kann einen Wechselstrom bereitstellen, welcher als hochfrequentes Signal von der Sendeeinheit in ein Volumen der Kieferregion des Patienten ausgesendet wird und ein B1-Magnetfeld erzeugt.

In einer weiteren Ausführungsform ist ein Empfangselement der zweiten Antenneneinheit mittels einer elektrischen Anschlussleitung mit einem Empfängerkanal der Magnetresonanzvorrichtung verbunden. Die Magnetresonanzvorrichtung ist somit in der Lage, Magnetresonanzsignale der Kieferregion des Patienten zu empfangen und Magnetresonanzbilder in Abhängigkeit der empfangenen Magnetresonanzsignale zu erstellen.

Durch die erfindungsgemäße Magnetresonanzvorrichtung lässt sich eine zeiteffiziente und wiederholbare Aufnahme von Magnetresonanzbildern eines Untersuchungsobjekts realisieren. Die erfindungsgemäße Magnetresonanzvorrichtung teilt die Vorteile der erfindungsgemäßen Lokalspule.

In einer bevorzugten Ausführungsform weist die erfindungsgemäße Magnetresonanzvorrichtung eine Patientenlagerungsvorrichtung auf.

Eine Patientenlagerungsvorrichtung ist vorzugsweise dazu ausgebildet, das Untersuchungsobjekt während einer Magnetresonanzuntersuchung zu stützen und/oder in einer vorbestimmten Relativposition zu der Magnetresonanzvorrichtung zu halten. Die Patientenlagerungsvorrichtung kann beispielsweise als ein Patiententisch, eine Patientenliege oder ein Patientenstuhl ausgestaltet sein.

Gemäß einer Ausführungsform ist das Halteelement der Lokalspule mechanisch mit der Patientenlagerungsvorrichtung verbunden, wobei die Patientenlagerungsvorrichtung und/oder das Halteelement eine Positionierungseinheit aufweisen, welche dazu ausgebildet ist, eine relative Position und/oder Ausrichtung der zweiten Antenneneinheit zu der Patientenlagerungsvorrichtung zu verändern.

Das Halteelement kann mechanisch mit der Magnetresonanzvorrichtung, insbesondere einem Patiententisch, verbunden sein. Es ist aber ebenso vorstellbar, dass das Halteelement eine von der Magnetresonanzvorrichtung getrennte Komponente ist.

Das Halteelement kann in diesem Fall an einer Wand und/oder einer Decke eines Untersuchungsraums der Magnetresonanzvorrichtung montiert sein oder reversibel mit der Patientenlagerungsvorrichtung verbindbar sein. Vorzugsweise weist das Halteelement zumindest eine Positionierungseinheit auf, welche dazu ausgebildet ist, eine Position des Halteelements und/oder der zweiten Antenneneinheit der Lokalspule relativ zu dem Patiententisch und/oder dem Untersuchungsobjekt zu verändern. Es ist insbesondere vorstellbar, dass die Positionierungseinheit dazu ausgelegt ist, eine räumliche Position und/oder eine räumliche Ausrichtung der zweiten Antenneneinheit relativ zu der ersten Antenneneinheit zu verändern.

Durch das Bereitstellen einer Magnetresonanzvorrichtung mit einem Halteelement und/oder einer Positionierungseinheit lässt sich eine Position und/oder Ausrichtung der zweiten Antenneneinheit relativ zu einer Patientenlagerungsvorrichtung mit einem Untersuchungsobjekt einstellen. Dadurch lässt sich eine Qualität einer induktiven Kopplung zwischen der ersten Antenneneinheit und der zweiten Antenneneinheit für eine Magnetresonanzuntersuchung eines Untersuchungsobjekts, insbesondere einer Kieferregion eines Patienten, auf vorteilhafte Weise verbessern oder optimieren.

Weiterhin kann die zweite Antenneneinheit durch das Bereitstellen eines erfindungsgemäßen Halteelements und/oder einer erfindungsgemäßen Positionierungseinheit auf vorteilhafte Weise genau und wiederholbar in der anwendungsgemäßen Position relativ zu einem Untersuchungsobjekt positioniert werden.

Weitere Vorteile und Einzelheiten ergeben sich aus der nachfolgenden Beschreibung von Ausführungsbeispielen in Verbindung mit den Zeichnungen. Es zeigen in Prinzipdarstellung:
- Fig. 1: eine mögliche Ausführungsform eines erfindungsgemäßen Magnetresonanzsystems,
- Fig. 2: eine mögliche Ausführungsform einer erfindungsgemäßen Lokalspule,
- Fig. 3: eine mögliche Ausführungsform einer erfindungsgemäßen Lokalspule,
- Fig. 4: eine mögliche Ausführungsform einer erfindungsgemäßen Lokalspule,
- Fig. 5: eine mögliche Ausführungsform einer erfindungsgemäßen Lokalspule,
- Fig. 6: eine mögliche Ausführungsform einer erfindungsgemäßen Lokalspule,
- Fig. 7: eine mögliche Ausführungsform einer erfindungsgemäßen Lokalspule,
- Fig. 8: eine Ausführungsform einer erfindungsgemäßen Magnetresonanzvorrichtung mit einer erfindungsgemäßen Lokalspule.

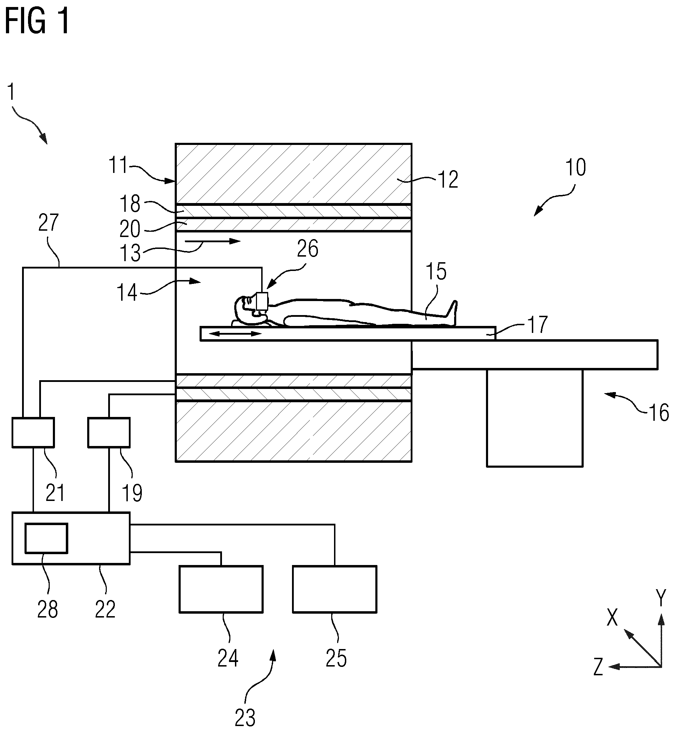

In Fig. 1 ist eine mögliche Ausführungsform eines Magnetresonanzsystems 1 mit einer Magnetresonanzvorrichtung 10 und einer Lokalspule 26 schematisch dargestellt. Die Magnetresonanzvorrichtung 10 umfasst eine Magneteinheit 11, welche z. B. einen Permanentmagneten, einen Elektromagneten oder einen supraleitenden Hauptmagneten 12 zur Erzeugung eines starken und insbesondere homogenen Grundmagnetfelds 13 (B0-Magnetfeld) aufweist. Zudem umfasst die Magnetresonanzvorrichtung 10 einen Patientenaufnahmebereich 14 zu einer Aufnahme eines Untersuchungsobjekts 15, insbesondere eines Patienten 15. Der Patientenaufnahmebereich 14 ist in dem vorliegenden Ausführungsbeispiel zylinderförmig ausgebildet und in einer Umfangsrichtung von der Magneteinheit 11 umgeben. Grundsätzlich sind jedoch auch von diesem Beispiel abweichende Ausgestaltungen des Patientenaufnahmebereichs 14 vorstellbar.

Der Patient 15 kann mittels eines Patientenpositionierungssystems 16 der Magnetresonanzvorrichtung 10 in dem Patientenaufnahmebereich 14 positioniert werden. Das Patientenpositionierungssystem 16 weist hierfür einen innerhalb des Patientenaufnahmebereichs 14 bewegbar ausgestalteten Patiententisch 17 auf. Abweichend von dem gezeigten Patiententisch 17 kann die Magnetresonanzvorrichtung selbstverständlich auch alternative Patientenlagerungsvorrichtungen, wie z. B. eine Patientenliege, einen Patientenstuhl, eine Patientencouch oder dergleichen, aufweisen.

Die Magneteinheit 11 weist weiterhin eine Gradientenspule 18 zum Erzeugen von magnetischen Gradientenfeldern auf, welche für eine Ortskodierung während einer Magnetresonanzuntersuchung verwendet wird. Die Gradientenspule 18 wird mittels einer Gradientensteuereinheit 19 der Magnetresonanzvorrichtung 10 angesteuert. Die Magneteinheit 11 kann weiterhin eine Hochfrequenzantenne umfassen, welche im vorliegenden Ausführungsbeispiel als fest in die Magnetresonanzvorrichtung 10 integrierte Körperspule 20 ausgebildet ist. Die Körperspule 20 ist zu einer Anregung von Atomkernen ausgelegt, die sich in dem von dem Hauptmagneten 12 erzeugten Grundmagnetfeld 13 befinden. Die Körperspule 20 wird von einer Hochfrequenzeinheit 21 der Magnetresonanzvorrichtung 10 angesteuert und strahlt hochfrequente Signale in einen Untersuchungsraum ein, der im Wesentlichen von einem Patientenaufnahmebereich 14 der Magnetresonanzvorrichtung 10 gebildet ist. Die Körperspule 20 kann weiterhin auch zu einem Empfangen von Magnetresonanzsignalen ausgebildet sein.

Für eine Steuerung des Hauptmagneten 12, der Gradientensteuereinheit 19 und der Hochfrequenzeinheit 21 weist die Magnetresonanzvorrichtung 10 eine Steuereinheit 22 auf. Die Steuereinheit 22 ist dazu ausgebildet eine Durchführung einer Sequenz, wie z. B. einer bildgebenden Gradientenechosequenz, einer TSE-Sequenz oder einer UTE-Sequenz, zu steuern. Zudem umfasst die Steuereinheit 22 eine Recheneinheit 28 zu einer Auswertung von digitalisierten Magnetresonanzsignalen, welche während der Magnetresonanzuntersuchung erfasst werden. Die Recheneinheit 28 kann ebenso dazu ausgebildet sein, Rekonstruktionsmethoden einzusetzen, um Bilddaten aus reduzierten Mengen von k-Raum Daten bei Einsatz von parallelen Bildgebungsverfahren zu rekonstruieren.

Des Weiteren umfasst die Magnetresonanzvorrichtung 10 eine Benutzerschnittstelle 23, welche eine Signalverbindung mit der Steuereinheit 22 aufweist. Steuerinformationen, wie beispielsweise Bildgebungsparameter und rekonstruierte Magnetresonanzbilder, können auf einer Anzeigeeinheit 24, beispielsweise auf zumindest einem Monitor, der Benutzerschnittstelle 23 für einen Nutzer angezeigt werden. Weiterhin weist die Benutzerschnittstelle 23 eine Eingabeeinheit 25 auf, mittels der Parameter einer Magnetresonanzuntersuchung von dem Nutzer eingegeben werden können.

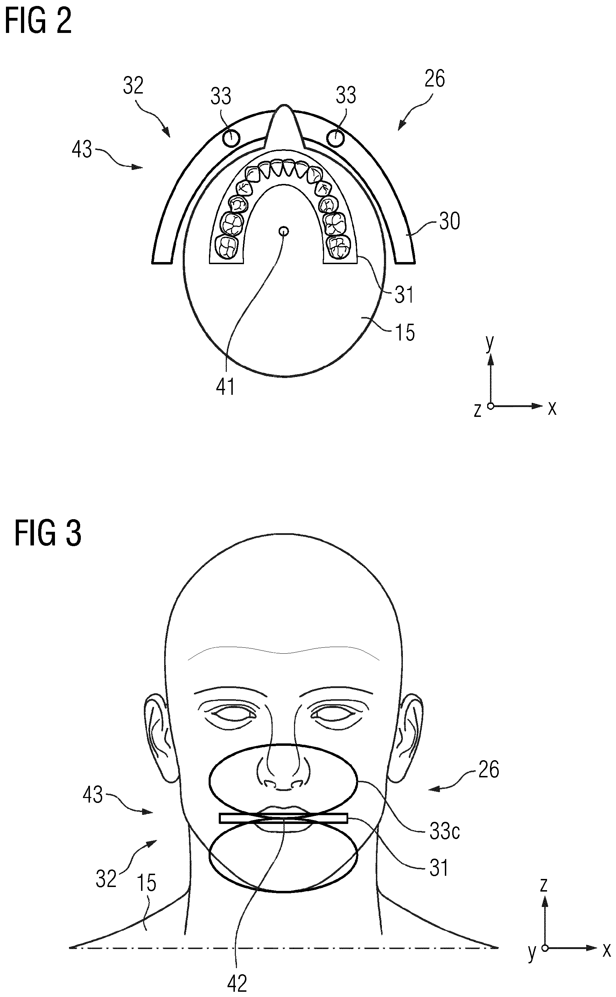

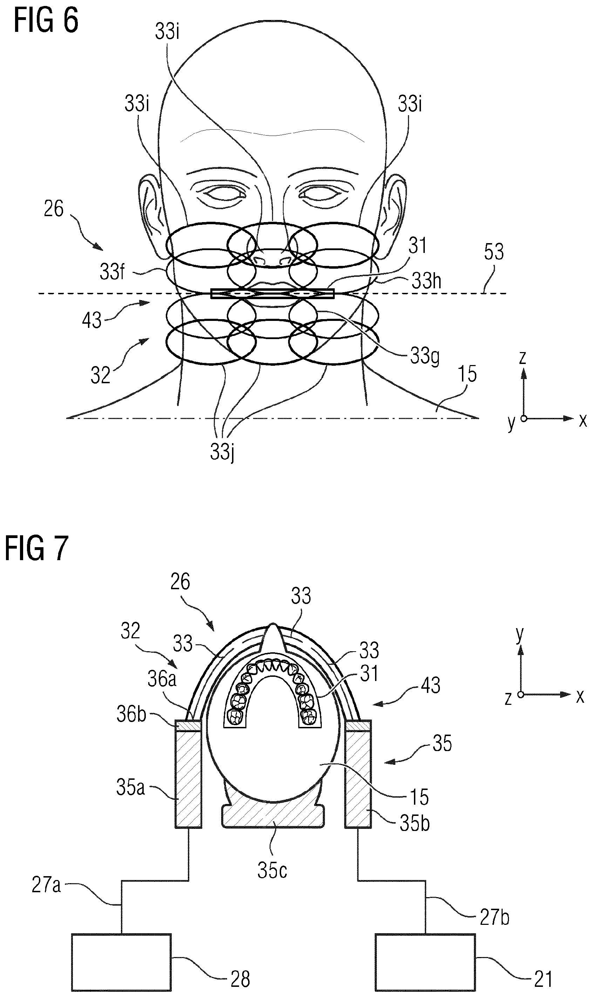

Ferner weist die Magnetresonanzvorrichtung 10 eine Lokalspule 26 auf, welche in dem in Fig. 1 gezeigten Beispiel in einer anwendungsgemäßen Position an einer Kieferregion 43 eines Patienten 15 positioniert ist (vgl. Fig. 2) und Magnetresonanzsignale basieren auf Kernspinresonanzen aus einem Volumen der Kieferregion 43 an die Magnetresonanzvorrichtung 10 überträgt. Die Lokalspule 26 ist vorzugsweise mit einer elektrischen Anschlussleitung 27 verbunden, welche eine Signalverbindung mit der Hochfrequenzeinheit 21, aber auch der Steuereinheit 22 bereitstellt. Ebenso wie die Körperspule 20 kann auch die Lokalspule 26 zu einer Anregung von Atomkernen und zu einem Empfangen von Magnetresonanzsignalen ausgebildet sein. Hierfür kann die Lokalspule 26 beispielweise eine Sendeeinheit (nicht gezeigt) aufweisen, welche zum Aussenden von hochfrequenten Signalen von der Hochfrequenzeinheit 21 angesteuert wird. Die Lokalspule 26 kann den Kopf des Patienten 15 außenumfänglich entlang einer Längserstreckung des Patienten 15 zumindest teilweise umschließen. Die Lokalspule 26 kann weiterhin ein Halteelement 35 aufweisen (vgl. Fig. 7), welches dazu ausgebildet ist, die Lokalspule 26 bzw. die zweite Antenneneinheit 32 der Lokalspule 26 in einer anwendungsgemäßen relativen Position zu der ersten Antenneneinheit 31 und dem Patienten 15 zu halten oder zu fixieren.

Die dargestellte Magnetresonanzvorrichtung 10 kann selbstverständlich weitere Komponenten umfassen, welche Magnetresonanzvorrichtungen üblicherweise aufweisen. Es ist ebenso vorstellbar, dass die Magnetresonanzvorrichtung 10 statt des zylinderförmigen Aufbaus einen C-förmigen, einen dreieckigen oder einen asymmetrischen Aufbau der Magnetfeld-erzeugenden Komponenten aufweist. Die Magnetresonanzvorrichtung 10 kann insbesondere eine dedizierte Magnetresonanzvorrichtung 10 sein, welche dazu ausgebildet ist, eine Magnetresonanzbildgebung der Kieferregion 43 eines stehenden oder sitzenden Patienten 15 durchzuführen.

Fig. 2 zeigt eine Schnittansicht eines Patienten 15 mit einer erfindungsgemäßen Lokalspule 26 in einer anwendungsgemäßen Position relativ zu dem Patienten 15. Die erste Antenneneinheit 31 ist einem Zahnbogen des Patienten 15 nachgeformt und weist eine im Wesentlichen planare Gestalt auf. Vorliegend ist die erste Antenneneinheit 31 anwendungsgemäß in einer Okklusionsebene zwischen einem oberen Zahnbogen und einem unteren Zahnbogen des Patienten 15 positioniert. Vorzugsweise ist eine Oberfläche der ersten Antenneneinheit 31 hinsichtlich Biokompatibilität und Berührschutz so geschaffen, dass der Patient 15 auf die erste Antenneneinheit aufbeißen kann, um diese während der Magnetresonanzuntersuchung zu arretieren.

Die zweite Antenneneinheit 32 ist in einer vorbestimmten relativen Position zu der ersten Antenneneinheit 31 positioniert. Bei anwendungsgemäßer Positionierung der Lokalspule 26 liegt ein Winkel zwischen einer Flächennormalen einer Hauptoberfläche der ersten Antenneneinheit 31 und einer Flächennormalen einer Hauptoberfläche der zweiten Antenneneinheit 32 in einem Bereich zwischen 60° und 120°. Vorzugsweise ist die Flächennormale der Hauptoberfläche der ersten Antenneneinheit 31 im Wesentlichen orthogonal zu der Flächennormalen der Hauptoberfläche der zweiten Antenneneinheit 32 ausgerichtet. Vorliegend sind die erste Antenneneinheit 31 und die zweite Antenneneinheit 32 bei anwendungsgemäßer Positionierung der Lokalspule 26 relativ zu dem Patienten 15 derart angeordnet, dass ein geometrischer Mittelpunkt 41 der ersten Antenneneinheit 31 in einem Schnittpunkt einer Flächennormalen der Hauptoberfläche der zweiten Antenneneinheit 32 mit einer Flächennormalen der ersten Antenneneinheit 31 liegt.

In dem gezeigten Beispiel weist die zweite Antenneneinheit 32 zumindest ein Empfangselement 33 auf. Das Empfangselement 33 ist gemäß einer erfindungsgemäßen Variante als eine Butterfly-Spule ausgestaltet. Die zweite Antenneneinheit 32 kann eine Mehrzahl von Empfangselementen 33 aufweisen. Vorzugsweise umfasst die zweite Antenneneinheit 32 eine Trägerstruktur 30, welche mechanisch mit dem Empfangselement 33 oder der Mehrzahl von Empfangselementen 33 verbunden ist. Das Empfangselement 33 oder die Mehrzahl von Empfangselementen 33 kann weiterhin in die Trägerstruktur 30 eingebettet sein. Die Trägerstruktur 30 kann als ein Teil oder ein Abschnitt eines Halteelements 35 ausgestaltet sein (siehe Fig. 6), welches dazu ausgebildet ist, die zweite Antenneneinheit 32 in einer vorbestimmten relativen Position zu der ersten Antenneneinheit 31 zu halten, sodass die induktive Kopplung zwischen der ersten Antenneneinheit 31 und der zweiten Antenneneinheit 32 erreicht wird. Die Trägerstruktur 30 kann aber auch mechanisch mit dem Halteelement 35 verbunden sein.

Wie in Fig. 2 gezeigt, ist die zweite Antenneneinheit 32 vorzugsweise einem Hohlzylindersektor nachgeformt. Die zweite Antenneneinheit 32 kann somit die Kieferregion 43 des Patienten 15, aber auch die erste Antenneneinheit 31, zumindest teilweise entlang der Außenkontur der Kieferregion 43 umschließen oder umranden. Ein Querschnitt der zweiten Antenneneinheit 32 kann wie dargestellt eine konvex-konkave Gestalt aufweisen. Die erste Antenneneinheit 31 ist bei anwendungsgemäßer Positionierung der Lokalspule 26 relativ zu dem Patienten 15 von der Oberfläche der zweiten Antenneneinheit 32 mit der konkaven Form zumindest teilweise entlang einer Umfangsrichtung der ersten Antenneneinheit 31 umgeben oder umschlossen.

Fig. 3 zeigt eine Frontalansicht eines Patienten 15 mit einer erfindungsgemäßen Lokalspule 26. Die zweite Antenneneinheit 32 ist in einer anwendungsgemäßen Position an der Kieferregion 43 des Patienten 15 positioniert. Eine Darstellung einer Trägerstruktur 30 wurde zugunsten einer besseren Nachvollziehbarkeit der Anordnung von Empfangselementen 33 vermieden. Die Trägerstruktur 30 kann bei anwendungsgemäßer Positionierung der Lokalspule 26 in einem geringen Abstand zu einer Hautoberfläche der Kieferregion 43 des Patienten 15 positioniert sein. Der Abstand zwischen der zweiten Antenneneinheit 32 und der Hautoberfläche der Kieferregion 43 des Patienten kann z. B. zwischen einem Millimeter und zehn Millimetern betragen. Es ist jedoch ebenso vorstellbar, dass der Abstand zwischen der zweiten Antenneneinheit 32 und der Hautoberfläche der Kieferregion 43 des Patienten 15 geringer ist oder dass die zweite Antenneneinheit 32 zumindest teilweise an der Hautoberfläche des Patienten 15 anliegt.

In dem in Fig. 3 gezeigten Beispiel weist die zweite Antenneneinheit 32 ein Empfangselement 33c auf, welches als Butterfly-Spule ausgestaltet ist. Ein Kreuzungspunkt des Signalleiters der Butterfly-Spule ist vorliegend in einer Ebene mit der ersten Antenneneinheit 31 angeordnet. Die beiden Schlaufen des Signalleiters der Butterfly-Spule 33 sind vorzugsweise jeweils an einem Unterkiefer und einem Oberkiefer des Patienten 15 angeordnet.

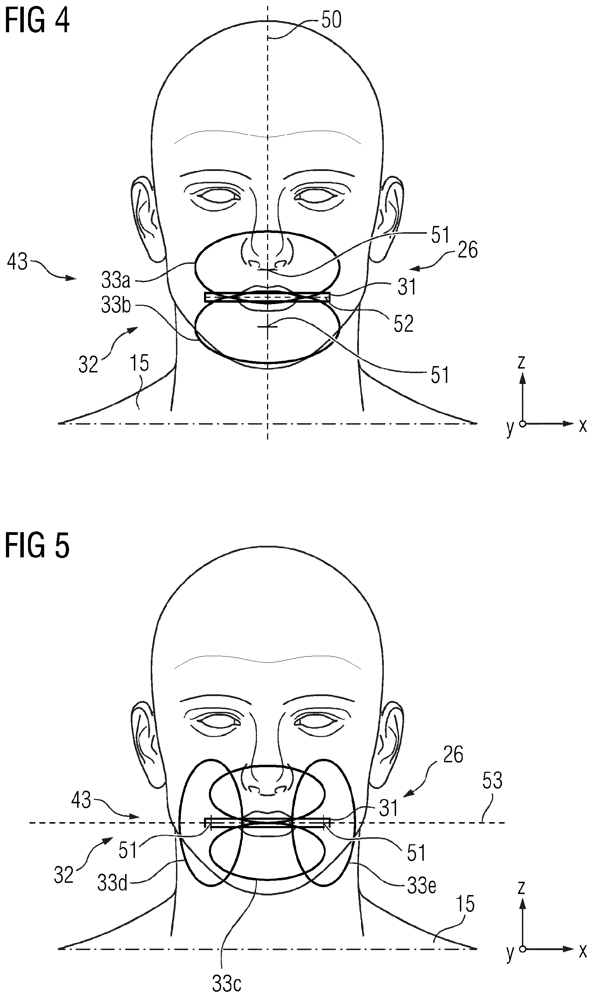

Fig. 4 zeigt eine Ausführungsform der erfindungsgemäßen Lokalspule 26, bei welcher die zweite Antenneneinheit 32 zwei Empfangselemente 33a und 32b (32a-b) aufweist. Geometrische Mittelpunkte 51 der zwei Empfangselemente 33a-b sind bei anwendungsgemäßer Positionierung der zweiten Antenneneinheit 32 an der Kieferregion 43 entlang einer Sagittalebene 50 des Patienten 15 angeordnet. In dem gezeigten Beispiel überlagern sich die zumindest zwei Empfangselemente 33a-b teilweise.

Die zumindest zwei Empfangselemente 33a-b können derart entlang der Oberflächenkontur der zweiten Antenneneinheit 32 angeordnet sein, dass eine Schnittgerade 52 der zumindest zwei Empfangselemente 33a-b parallel zu einer Hauptoberfläche einer Empfangsspule der ersten Antenneneinheit 31 angeordnet ist und/oder mit einer Ebene der ersten Antenneneinheit 31 zusammenfällt.

Es ist vorstellbar, dass neben den in Fig. 3 und Fig. 4 gezeigten Empfangselementen 33 noch weitere Empfangselemente 33 entlang der Oberflächenkontur der zweiten Antenneneinheit 32 und/oder der Trägerstruktur 30 angeordnet sind.

Fig. 5 zeigt eine weitere Ausführungsform der erfindungsgemäßen Lokalspule 26. Die zweite Antenneneinheit 32 weist vorliegend drei Empfangselemente 33c, 33d und 33e (33c-e) auf. Das Empfangselement 33c ist dabei als eine Butterfly-Spule ausgestaltet, welche im Wesentlichen der in Fig. 3 gezeigten Ausführungsform entspricht.

Die geometrischen Mittelpunkte 51 der drei Empfangselemente 33c-e sind entlang der Transversalebene 53 des Patienten 15 angeordnet. Weiterhin sind die geometrischen Mittelpunkte 51 der zumindest zwei Empfangselemente 33d und 33e entlang einer Geraden angeordnet, welche parallel zu einer Hauptoberfläche der ersten Antenneneinheit 31 und/oder der Okklusionsebene des Patienten 15 orientiert ist.

Im vorliegenden Beispiel flankieren die beiden Empfangselemente 33d und 33e das Empfangselement 33c entlang der Z-Richtung. Die Signalleiter der Empfangselemente 33d und 33e können den Signalleiter des Empfangselements 33c wie in Fig. 5 gezeigt kreuzen oder überlagern. Es ist jedoch ebenso vorstellbar, dass die Signalleiter der Empfangselemente 33d und 33e derart neben dem Signalleiter des Empfangselements 33c angeordnet sind, dass ein Kreuzen von Signalleitern vermieden wird.

Es ist weiterhin vorstellbar, dass anstelle der Butterfly-Spule 33c zwei Empfangselemente 33a und 33b entlang der Oberflächenkontur der zweiten Antenneneinheit 32 angeordnet sind. Die zweite Antenneneinheit 32 weist in diesem Fall vier Empfangselemente 33a, 33b, 33d und 33e auf. Dabei können die geometrischen Mittelpunkte 51 der zwei Empfangselemente 33d und 33e entlang einer Geraden angeordnet sein, welche parallel zu einer Hauptoberfläche der ersten Antenneneinheit 31 und/oder einer Okklusionsebene des Patienten 15 orientiert ist. Es ist ebenso vorstellbar, dass die geometrischen Mittelpunkte 51 zweier als Butterfly-Spulen ausgestalteten Empfangselemente 33d und 33e im Wesentlichen in einer Ebene mit einer Hauptoberfläche ersten Antenneneinheit 31 liegen.

Weiterhin können die geometrischen Mittelpunkte 51 der zwei Empfangselemente 33a und 33b entlang der Sagittalebene 50 des Patienten 15 angeordnet sein (vgl. Fig. 4).

Vorzugsweise weist die zweite Antenneneinheit 32 anstelle der gezeigten Empfangselemente 33d und 33e jeweils zwei Empfangselemente 33d.1 und 33d.2 sowie 33e.1 und 33e.2 auf (nicht gezeigt), deren geometrische Mittelpunkte jeweils wie in Fig. 4 gezeigt versetzt entlang einer Sagittalebene des Patienten 15 angeordnet sind. Dabei können die geometrischen Mittelpunkte 51 der zwei Empfangselemente 33d.1 und 33e.1 bzw. 33d.2 und 33e.2 jeweils entlang einer Geraden angeordnet sein, welche parallel und in einem Abstand oberhalb oder unterhalb zu einer Hauptoberfläche der ersten Antenneneinheit 31 und/oder einer Okklusionsebene des Patienten 15 angeordnet ist.

Fig. 6 zeigt eine weitere Ausführungsform der erfindungsgemäßen Lokalspule 26. In diesem Beispiel weist die zweite Antenneneinheit 32 insgesamt neun Empfangselemente 33f bis 33j (33f-j) auf. Die drei Empfangselemente 33f, 33g und 33h (33f-h) sind vorliegend als Butterfly-Spulen ausgestaltet, deren geometrische Mittelpunkte oder Kreuzungspunkte (nicht gezeigt) entlang der Transversalebene 53 des Patienten 15 angeordnet sind. Insbesondere sind die geometrischen Mittelpunkte der beiden Butterfly-Spulen 33f und 33h entlang einer Geraden angeordnet, welche parallel zu der Hauptoberfläche der ersten Antenneneinheit 31 und/oder einer Okklusionsebene des Patienten 15 orientiert ist.

Weiterhin wird jede Butterflyspule 33f-h entlang der X-Richtung von zwei Empfangselementen 33i und 33j flankiert. Die Signalleiter einer Butterfly-Spule 33f, 33g oder 33h können sich dabei mit Signalleitern der Empfangselemente 33i und/oder 33j kreuzen. Es ist aber ebenso vorstellbar, dass die Empfangselemente 33f-j derart angeordnet sind, dass ein Überlagern von Empfangselementen 33 oder ein Kreuzen von Signalleitern vermieden wird.

Es ist weiterhin vorstellbar, dass die zweite Antenneneinheit 32 anstelle einer oder mehrerer Butterfly-Spulen 33f-h jeweils zwei Empfangsspulen 33a und 33b gemäß einer oben beschriebenen Ausführungsform aufweist.

Vorzugsweise sind die in den Figuren 3 bis 6 gezeigten Butterfly-Spulen 33c, 33f, 33g und/oder 33h und die Empfangselemente 33a, 33b, 33d, 33e, 33i und/oder 33j galvanisch getrennt, um ein separates Auslesen einzelner Empfangselemente 33 zu ermöglichen.

Je zwei Empfangselemente 33 einer oben beschriebenen Ausführungsform können beispielsweise einen Überlappungsbereich mit einer Abmessung von 0,5 cm bis 2 cm aufweisen. Es ist weiterhin vorstellbar, dass die Trägerstruktur 30 einen Kompensationsmechanismus (nicht gezeigt) aufweist, welcher einen Überlappungsbereich zwischen den zwei benachbarten Empfangselementen 33 bei einer Verformung der Trägerstruktur 30 anpasst. Durch den Überlappungsbereich können die Empfangselemente 33 induktiv voneinander entkoppelt werden.

Die Empfangselemente 33 der zweiten Antenneneinheit 32 können in ein Material der Trägerstruktur 30 eingebettet sein und/oder formschlüssig, kraftschlüssig und/oder stoffschlüssig mit der Trägerstruktur 30 verbunden sein.

Fig. 7 zeigt eine Ausführungsform der erfindungsgemäßen Lokalspule 26, bei welcher die zweite Antenneneinheit 32 mechanisch mit einem Halteelement 35 verbunden ist. Das Halteelement 35 ist dazu ausgebildet, die zweite Antenneneinheit 32 in einer vorbestimmten relativen Position zu der ersten Antenneneinheit 31 und der Kieferregion 43 des Patienten 15 zu halten.

Beispielsweise können die zweite Antenneneinheit 32 und das Halteelement 35 komplementär zueinander ausgebildete Steckelemente 36a und 36b aufweisen, welche bei ordnungsgemäßer Zusammenführung der zweiten Antenneneinheit 32 und des Halteelements 35 ineinandergreifen. Dadurch kann ein unwillkürliches Verschieben oder Verrücken der zweiten Antenneneinheit 32 durch eine Bewegung des Patienten 15 vermieden werden. Die Steckelemente 36a und 36b können weiterhin dazu ausgebildet sein, eine elektrische Verbindung der zweiten Antenneneinheit 32 mit der elektrischen Anschlussleitung 27 bereitzustellen. In dem gezeigten Beispiel werden empfangene Magnetresonanzsignale der zweiten Antenneneinheit 32 mittels der elektrischen Anschlussleitung 27a an die Recheneinheit 28 der Magnetresonanzvorrichtung 10 übertragen. Die Recheneinheit 28 kann anschließend ein Magnetresonanzbild aus den empfangenen Magnetresonanzsignalen rekonstruieren.

Sofern die zweite Antenneneinheit 32 eine Sendeeinheit aufweist, kann ein Wechselstrom mittels der elektrischen Anschlussleitung 27b von der Hochfrequenzeinheit 21 über die Steckelemente 36a und 36b an die Sendeeinheit der Lokalspule 26 übertragen werden, welche daraufhin ein hochfrequentes Signal in die Kieferregion 43 des Patienten 15 aussendet.

In dem in Fig. 7 gezeigten Beispiel sind die elektrischen Anschlussleitungen 27a und 27b für eine bessere Nachvollziehbarkeit an gegenüberliegenden Seiten des Halteelements 35 angeordnet. Selbstverständlich kann die zweite Antenneneinheit 32 mittels getrennter oder gemeinsamer Steckverbindungen (36a, 36b) und/oder an beliebigen Positionen der zweiten Antenneneinheit 32 oder der Trägerstruktur 30 mit den elektrischen Anschlussleitungen 27a und 27b verbunden sein.

Das Halteelement 35 weist in dem vorliegenden Beispiel eine Mehrzahl von mechanisch getrennten Komponenten auf. Neben den zwei Streben 35a und 35b, welche die Steckelemente 36b aufweisen, umfasst das Halteelement 35 auch eine Kopfschale 35c, welche dazu ausgebildet ist, eine Bewegung des Kopfes des Patienten 15 während der Magnetresonanzuntersuchung einzuschränken oder zu verhindern.

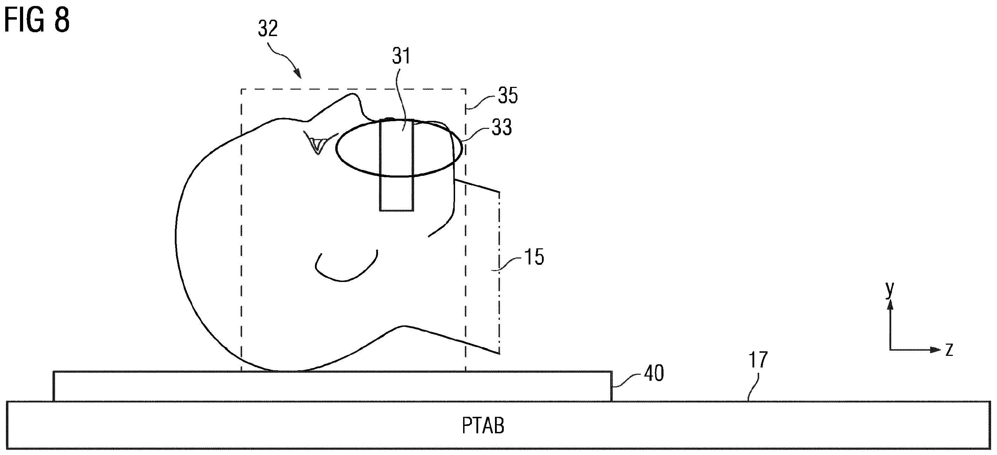

Fig. 8 zeigt eine Ausführungsform der erfindungsgemäßen Magnetresonanzvorrichtung 10, bei welcher das Halteelement 35 mechanisch mit dem Patiententisch 17 des Patientenpositionierungssystems 16 (siehe Fig. 1) verbunden ist. Der Patient 15 ist in dem gezeigten Beispiel liegend auf dem Patiententisch 17 ausgerichtet. Der Kopf des Patienten 15 kann auf einem Kopfbett 35c oder einer beliebigen Kopfstütze positioniert sein, welche dazu ausgelegt sein kann, den Kopf des Patienten 15 aufzunehmen, zu stützen und/oder zu stabilisieren. Das Halteelement 35 weist beispielsweise einen einstückigen Körper oder Streben 35a und 35b (vgl. Fig. 7) auf, welche die Antenneneinheit 32 in einer vorbestimmten relativen Position zu der ersten Antenneneinheit 31 und der Kieferregion 43 des

Patienten 15 halten. Die zweite Antenneneinheit 32 kann mittels einer Steckverbindung (36a, 36b) oder einer beliebigen reversiblen mechanischen Verbindung mit den Streben 35a und 35b bzw. dem Körper des Halteelements 35 verbunden sein.

Ferner weist das Halteelement 35 vorliegend eine Positionierungseinheit 40 auf, welche dazu ausgebildet ist, eine Position des Halteelements 35 und/oder der zweiten Antenneneinheit 32 zumindest entlang der Z-Richtung relativ zu dem Patiententisch 17 zu verändern. Die Positionierungseinheit 40 kann beispielweise als ein Führungsmechanismus, wie z. B. eine Schiene, ausgestaltet sein, welcher ein manuelles und/oder automatisiertes Verschieben der zweiten Antenneneinheit 32 entlang der Z-Richtung ermöglicht.

Die Positionierungseinheit 40 kann weiterhin dazu ausgebildet sein, eine relative Ausrichtung der zweiten Antenneneinheit 32 zu der ersten Antenneneinheit 31, dem Patienten 15 und/oder dem Patiententisch 17 zu ermöglichen. Die Positionierungseinheit 40 kann beispielsweise ein Scharnier, ein Gelenk und/oder einen Schwenkmechanismus aufweisen (nicht gezeigt), welcher dazu ausgebildet ist, die zweite Antenneneinheit 32 in einer Raumrichtung oder in mehreren Raumrichtungen zu verkippen oder zu schwenken.

Es ist vorstellbar, dass die erfindungsgemäße Lokalspule 26 eine einzige Positionierungseinheit 40 aufweist, welche dazu ausgebildet ist, eine Orientierung und/oder eine Position der zweiten Antenneneinheit 32 relativ zu der ersten Antenneneinheit 31 und/oder dem Patienten 15 zu verändern. Es ist ebenso vorstellbar, dass die Positionierungseinheit 40 zumindest einen ersten Justierungsmechanismus und einen zweiten Justierungsmechanismus umfasst. Der erste Justierungsmechanismus kann beispielsweise dazu ausgebildet sein, eine Position der zweiten Antenneneinheit 32 entlang der Z-Richtung zu verändern, während der zweite Justierungsmechanismus dazu ausgebildet ist, eine Orientierung der zweiten Antenneneinheit 32 relativ zu dem Patienten 15 und/oder der Patientenlagerungsvorrichtung 16 zu verändern.

Obwohl die Erfindung im Detail durch die bevorzugten Ausführungsbeispiele näher illustriert und beschrieben wurde, so ist die Erfindung dennoch nicht durch die offenbarten Beispiele eingeschränkt und andere Variationen können vom Fachmann hieraus abgeleitet werden, ohne den durch die Ansprüche definierten Schutzumfang der Erfindung zu verlassen.

## Patentansprüche

1. Lokalspule (26), umfassend eine erste Antenneneinheit (31) und eine zweite Antenneneinheit (32), wobei die erste Antenneneinheit (31) und die zweite Antenneneinheit (32) galvanisch getrennt sind und dazu ausgebildet sind, Magnetresonanzsignale eines Untersuchungsobjekts (15) zu empfangen, wobei es sich bei dem Untersuchungsobjekt (15) um eine Kieferregion eines Patienten handelt,
wobei bei anwendungsgemäßer Positionierung der Lokalspule (26) relativ zu dem Untersuchungsobjekt (15):
• die zweite Antenneneinheit (32) die erste Antenneneinheit (31) zumindest teilweise entlang einer Umfangsrichtung der ersten Antenneneinheit (31) umschließt, wobei
• die erste Antenneneinheit (31) eine im Wesentlichen planare Gestalt aufweist und dazu ausgebildet ist, entlang einer Okklusionsebene in einer Mundhöhle des Untersuchungsobjekts (15) angeordnet zu werden, wobei
• die zweite Antenneneinheit (32) an einer Außenoberfläche des Untersuchungsobjekts (15) angeordnet ist und wobei
• die zweite Antenneneinheit (32) eine induktive Kopplung mit der ersten Antenneneinheit (31) aufweist;
wobei die zweite Antenneneinheit (32) dazu ausgebildet ist, ein von der ersten Antenneneinheit (31) empfangenes Magnetresonanzsignal mittels der induktiven Kopplung zu erfassen, wobei
• die zweite Antenneneinheit (32) zumindest ein Empfangselement (33) aufweist, wobei das zumindest eine Empfangselement (33) als eine Butterfly-Spule ausgestaltet ist und wobei ein Kreuzungspunkt der Butterfly-Spule in einer Ebene mit der ersten Antenneneinheit angeordnet ist oder wobei
• die zweite Antenneneinheit (32) zumindest zwei Empfangselemente (33) aufweist, welche entlang einer Oberflächenkontur der zweiten Antenneneinheit (32) nebeneinander angeordnet sind oder sich zumindest teilweise überlagern, wobei die zumindest zwei Empfangselemente (33) dazu ausgebildet sind, unabhängig voneinander ausgelesen zu werden und wobei die zumindest zwei Empfangselemente eine Symmetrieebene oder eine Schnittgerade definieren, welche im Wesentlichen parallel zu einer Hauptoberfläche der ersten Antenneneinheit ausgerichtet ist.

2. Lokalspule nach Anspruch 1, ferner aufweisend ein Halteelement (35), welches dazu ausgebildet ist, die zweite Antenneneinheit (32) in einer vorbestimmten relativen Position zu der ersten Antenneneinheit (31) an der Außenoberfläche des Untersuchungsobjekts (15) zu halten.

3. Lokalspule nach Anspruch 2, wobei das Halteelement (35) dazu ausgebildet ist, die zweite Antenneneinheit (32) bei anwendungsgemäßer Positionierung der Lokalspule (26) relativ zu dem Untersuchungsobjekt (15) derart an der Außenoberfläche des Untersuchungsobjekts (15) zu halten, dass eine Flächennormale einer Hauptoberfläche der ersten Antenneneinheit (31) im Wesentlichen orthogonal zu einer Flächennormalen einer Hauptoberfläche der zweiten Antenneneinheit (32) ausgerichtet ist.

4. Lokalspule nach einem der vorhergehenden Ansprüche 2 oder 3, wobei das Halteelement (35) dazu ausgebildet ist, die zweite Antenneneinheit (32) derart an der Außenoberfläche des Untersuchungsobjekts (15) zu halten, dass ein geometrischer Mittelpunkt (41) der ersten Antenneneinheit (31) in einem Schnittpunkt einer Flächennormalen der Hauptoberfläche der zweiten Antenneneinheit (32) mit einer Flächennormalen der Hauptoberfläche der ersten Antenneneinheit (31) angeordnet ist.

5. Lokalspule nach einem der vorhergehenden Ansprüche, wobei die zweite Antenneneinheit (32) einem Hohlzylindersektor nachgeformt ist und das Untersuchungsobjekt (15) bei anwendungsgemäßer Positionierung der Lokalspule (26) relativ zu dem Untersuchungsobjekt (15) zumindest teilweise entlang einer Außenkontur des Untersuchungsobjekts (15) umschließt.

6. Lokalspule nach einem der vorhergehenden Ansprüche, wobei ein Empfangselement der ersten Antenneneinheit (31) in einer Ebene angeordnet ist, welche die erste Antenneneinheit (31) schneidet und parallel zu einer Hauptoberfläche der ersten Antenneneinheit (31) ausgerichtet ist, wobei ein geometrischer Mittelpunkt der zweiten Antenneneinheit (32) bei anwendungsgemäßer Positionierung der Lokalspule (26) relativ zu dem Untersuchungsobjekt (15) in der Ebene des Empfangselements der ersten Antenneneinheit (31) liegt.

7. Lokalspule nach einem der vorhergehenden Ansprüche, wobei die zweite Antenneneinheit (32) zumindest drei Empfangselemente (33) aufweist, wobei die zumindest drei Empfangselemente (33) entlang einer Oberflächenkontur der zweiten Antenneneinheit (32) nebeneinander angeordnet sind oder sich zumindest teilweise überlagern.

8. Lokalspule nach einem der vorhergehenden Ansprüche, wobei die zweite Antenneneinheit (32) einer Außenkontur der Kieferregion (43) des Patienten (15) nachgeformt ist und die Kieferregion (43) entlang der Außenkontur zumindest teilweise umschließt.

9. Lokalspule nach Anspruch 8, wobei geometrische Mittelpunkte (51) von zumindest zwei Empfangselementen (33) der zweiten Antenneneinheit (32) entlang einer Sagittalebene (50) des Patienten (15) angeordnet sind und wobei die zumindest zwei Empfangselemente (33) nebeneinander angeordnet sind oder sich zumindest teilweise überlagern.

10. Lokalspule nach einem der Ansprüche 8 oder 9, wobei geometrische Mittelpunkte (51) von zumindest drei Empfangselementen (33) der zweiten Antenneneinheit (32) entlang einer Transversalebene (53) des Patienten (15) angeordnet sind und wobei die zumindest drei Empfangselemente (33) nebeneinander angeordnet sind oder sich teilweise überlagern.

11. Lokalspule nach einem der Ansprüche 8 bis 10, wobei geometrische Mittelpunkte (51) von zumindest zwei Empfangselementen (33) der zweiten Antenneneinheit (32) entlang einer Geraden angeordnet sind, welche parallel zu einer Hauptoberfläche der ersten Antenneneinheit (31) und/oder einer Okklusionsebene des Patienten (15) ausgerichtet ist.

12. Magnetresonanzvorrichtung (10), aufweisend eine Lokalspule (26) nach einem der vorhergehenden Ansprüche, wobei die Magnetresonanzvorrichtung (10) dazu ausgebildet ist, von der ersten Antenneneinheit (31) empfangene Magnetresonanzsignale des Untersuchungsobjekts (15) mittels der induktiven Kopplung mit der zweiten Antenneneinheit (32) zu erfassen.

13. Magnetresonanzvorrichtung (10) nach Anspruch 12 mit einer Lokalspule (26) nach Anspruch 2, ferner aufweisend eine Patientenlagerungsvorrichtung (17), wobei das Halteelement (35) der Lokalspule (26) mechanisch mit der Patientenlagerungsvorrichtung (17) verbunden ist und wobei die Patientenlagerungsvorrichtung (17) und/oder das Halteelement (35) eine Positionierungseinheit (40) aufweisen, welche dazu ausgebildet ist, eine relative Position und/oder Ausrichtung der zweiten Antenneneinheit (32) zu der Patientenlagerungsvorrichtung (17) zu verändern.

## Claims

1. Local coil (26), comprising a first antenna unit (31) and a second antenna unit (32), wherein the first antenna unit (31) and the second antenna unit (32) are galvanically separated and are embodied to receive magnetic resonance signals of an examination object (15), wherein the examination object (15) is a jaw region of a patient,
wherein when the local coil (26) is positioned relative to the examination object (15) as per the application:
• the second antenna unit (32) encloses the first antenna unit (31) at least partially along a peripheral direction of the first antenna unit (31), wherein
• the first antenna unit (31) has a substantially planar design and is embodied to be arranged along an occlusion plane in an oral cavity of the examination object (15), wherein
• the second antenna unit (32) is arranged on an outer surface of the examination object (15), and wherein
• the second antenna unit (32) has an inductive coupling to the first antenna unit (31);
wherein the second antenna unit (32) is embodied to detect a magnetic resonance signal received by the first antenna unit (31) by means of the inductive coupling, wherein
• the second antenna unit (32) has at least one receive element (33), wherein the at least one receive element (33) is designed as a butterfly coil and wherein a point of intersection of the butterfly coil is arranged in a plane with the first antenna unit or wherein
• the second antenna unit (32) has at least two receive elements (33), which are arranged adjacent to one another along a surface contour of the second antenna unit (32) or at least partially overlap, wherein the at least two receive elements (33) are embodied to be read out independently of one another and wherein the at least two receive elements define a plane of symmetry or a line of intersection, which is aligned substantially parallel to a main surface of the first antenna unit.

2. Local coil according to claim 1, further having a holding element (35), which is embodied to hold the second antenna unit (32) in a predetermined position relative to the first antenna unit (31) against the outer surface of the examination object (15).

3. Local coil according to claim 2, wherein the holding element (35) is embodied to hold the second antenna unit (32) against the outer surface of the examination object (15), when the local coil (26) is positioned relative to the examination object (15) as per the application, such that a surface normal of a main surface of the first antenna unit (31) is aligned substantially orthogonally to a surface normal of a main surface of the second antenna unit (32).

4. Local coil according to one of the preceding claims 2 or 3, wherein the holding element (35) is embodied to hold the second antenna unit (32) against the outer surface of the examination object (15) in such a way that a geometric centre point (41) of the first antenna unit (31) is arranged in a point of intersection of a surface normal of the main surface of the second antenna unit (31) with a surface normal of the main surface of the first antenna unit (31).

5. Local coil according to one of the preceding claims, wherein the second antenna unit (32) is shaped to match a hollow cylinder sector and encloses the examination object (15) at least partially along an outer contour of the examination object (15) when the local coil (26) is positioned relative to the examination object (15) as per the application.

6. Local coil according to one of the preceding claims, wherein a receive element of the first antenna unit (31) is arranged in a plane, which intersects the first antenna unit (31) and is aligned parallel to a main surface of the first antenna unit (31), wherein a geometric centre point of the second antenna unit (32) lies in the plane of the receive element of the first antenna unit (31) when the local coil (26) is positioned relative to the examination object (15) as per the application.

7. Local coil according to one of the preceding claims, wherein the second antenna unit (32) has at least three receive elements (33), wherein the at least three receive elements (33) are arranged adjacent to one another along a surface contour of the second antenna unit (32) or at least partially overlap.

8. Local coil according to one of the preceding claims, wherein the second antenna unit (32) is shaped to match an outer contour of the jaw region (43) of the patient (15) and at least partially encloses the jaw region (43) along the outer contour.

9. Local coil according to claim 8, wherein geometric centre points (51) of at least two receive elements (33) of the second antenna unit (32) are arranged along a sagittal plane (50) of the patient (15) and wherein the at least two receive elements (33) are arranged adjacent to one another or at least partially overlap.

10. Local coil according to one of claims 8 or 9, wherein geometric centre points (51) of at least three receive elements (33) of the second antenna unit (32) are arranged along a transversal plane (53) of the patient (15) and wherein the at least three receive elements (33) are arranged adjacent to one another or partially overlap.

11. Local coil according to one of claims 8 to 10, wherein geometric centre points (51) of at least two receive elements (33) of the second antenna unit (32) are arranged along a straight line, which is aligned parallel to a main surface of the first antenna unit (31) and/or an occlusion plane of the patient (15).

12. Magnetic resonance apparatus (10), having a local coil (26) according to one of the preceding claims, wherein the magnetic resonance apparatus (10) is embodied to detect magnetic resonance signals of the examination object (15) received by the first antenna unit (31) by means of the inductive coupling to the second antenna unit (32).

13. Magnetic resonance apparatus (10) according to claim 12 with a local coil (26) according to claim 2, further having a patient support apparatus (17), wherein the holding element (35) of the local coil (26) is connected mechanically to the patient support apparatus (17), and wherein the patient support apparatus (17) and/or the holding element (35) have a positioning unit (40) which is embodied to change a position and/or alignment of the second antenna unit (32) relative to the patient support apparatus (17).

## Revendications

1. Bobine (26) locale, comprenant une première unité (31) d'antenne et une deuxième unité (32) d'antenne, dans laquelle la première unité (31) d'antenne et la deuxième unité (32) d'antenne sont séparées galvaniquement et sont constituées pour recevoir des signaux de résonance magnétique d'un objet (15) en examen, dans laquelle l'objet (15) en examen est la région de la mâchoire d'un patient,
dans laquelle, dans des mises en position suivant l'application de la bobine (26) locale par rapport à l'objet (15) en examen :
• la deuxième unité (32) d'antenne entoure la première unité (31) d'antenne au moins en partie le long d'une direction de pourtour de la première unité (31) d'antenne, dans laquelle
• la première unité (31) d'antenne a une forme sensiblement plane et est constituée pour être disposée suivant un plan d'occlusion dans une cavité buccale de l'objet (15) en examen, dans laquelle
• la deuxième unité (32) d'antenne est disposée sur une surface extérieure de l'objet (15) en examen et dans laquelle
• la deuxième unité (32) d'antenne a un couplage inductif avec la première unité (31) d'antenne ;
dans laquelle la deuxième unité (32) d'antenne est constituée pour détecter, au moyen du couplage inductif, un signal de résonance magnétique reçu par la première unité (31) d'antenne, dans laquelle
• la deuxième unité (32) d'antenne a au moins un élément (33) de réception, dans laquelle le au moins un élément (33) de réception est conformé sous la forme d'une bobine butterfly et dans laquelle un point d'intersection de la bobine butterfly est disposé dans un plan avec la première unité d'antenne, ou dans laquelle
• la deuxième unité (32) d'antenne a au moins deux éléments (33) de réception, qui sont disposés l'un à côté de l'autre le long d'un contour de surface de la deuxième unité (32) d'antenne ou sont superposés au moins en partie, dans laquelle les au moins deux éléments (33) de réception sont constitués pour être lus indépendamment l'un de l'autre, et dans laquelle les au moins deux éléments de réception définissent un plan de symétrie ou une droite de coupe, qui est dirigé sensiblement parallèlement à une surface principale de la première unité d'antenne.

2. Bobine locale suivant la revendication 1, comprenant en outre un élément (35) de maintien, qui est constitué pour maintenir la deuxième unité (32) d'antenne sur la surface extérieure de l'objet (15) en examen dans une position relative déterminée à l'avance par rapport à la première unité (31) d'antenne.

3. Bobine locale suivant la revendication 2, dans laquelle l'élément (35) de maintien est constitué pour, lors de la mise en position conforme à l'application de la bobine (26) locale par rapport à l'objet (15) en examen, maintenir la deuxième unité (32) d'antenne sur la surface extérieure de l'objet (15) en examen, de manière à ce qu'une normale à une surface principale de la première unité (31) d'antenne soit sensiblement orthogonale à une normale à une surface principale de la deuxième unité (32) d'antenne.

4. Bobine locale suivant l'une des revendications 2 ou 3 précédentes, dans laquelle l'élément (35) de maintien est constitué pour maintenir la deuxième unité (32) d'antenne sur la surface extérieure de l'objet (15) en examen, de manière à ce qu'un centre (41) géométrique de la première unité (31) d'antenne soit en un point d'intersection d'une normale à la surface principale de la deuxième unité (32) d'antenne et d'une normale à la surface principale de la première unité (31) d'antenne.

5. Bobine locale suivant l'une des revendications précédentes, dans laquelle la deuxième unité (32) d'antenne suit la forme d'un secteur de cylindre creux et, lors de la mise en position conforme à l'application de la bobine (26) locale par rapport à l'objet (15) en examen, entoure l'objet (15) en examen au moins en partie, le long d'un contour extérieur de l'objet (15) en examen.

6. Bobine locale suivant l'une des revendications précédentes, dans laquelle un élément de réception de la première unité (31) d'antenne est disposé dans un plan, qui coupe la première unité (31) d'antenne et qui est dirigé parallèlement à une surface principale de la première unité (31) d'antenne, dans laquelle un centre géométrique de la deuxième unité (32) d'antenne est, lors de la mise en position conforme à l'application de la bobine (26) locale relativement à l'objet (15) en examen, dans le plan de l'élément de réception de la première unité (31) d'antenne.

7. Bobine locale suivant l'une des revendications précédentes, dans laquelle la deuxième unité (32) d'antenne a au moins trois éléments (33) de réception, dans laquelle les au moins trois éléments (33) de réception sont disposés les uns à côté des autres le long d'un contour de surface de la deuxième unité (32) d'antenne ou sont superposés au moins en partie.

8. Bobine locale suivant l'une des revendications précédentes, dans laquelle la deuxième unité (32) d'antenne reproduit le contour extérieur de la région (43) buccale du patient (15) et entoure au moins en partie la région (43) buccale le long du contour extérieur.

9. Bobine locale suivant la revendication 8, dans laquelle des centres (51) géométriques d'au moins deux éléments (33) de réception de la deuxième unité (32) d'antenne sont disposés le long d'un plan (50) sagittal du patient (15) et dans laquelle les au moins deux éléments (33) de réception sont disposés l'un à côté de l'autre ou se superposent au moins partiellement.

10. Bobine locale suivant l'une des revendications 8 ou 9, dans laquelle des centres (51) géométriques d'au moins trois éléments (33) de réception de la deuxième unité (32) d'antenne sont disposés le long d'un plan (53) transversal du patient (15) et dans laquelle les au moins trois éléments (33) de réception sont disposés les uns à côté des autres ou se superposent partiellement.

11. Bobine locale suivant l'une des revendications 8 à 10, dans laquelle des centres (51) géométriques d'au moins deux éléments (33) de réception de la deuxième unité (32) d'antenne sont disposés le long d'une droite, qui est dirigée parallèlement à une surface principale de la première unité (31) d'antenne et/ou à un plan d'occlusion du patient (15).

12. Dispositif (10) de résonance magnétique, comportant une bobine (26) locale suivant l'une des revendications précédentes, dans lequel le dispositif (10) de résonance magnétique est constitué pour détecter des signaux de résonance magnétique de l'objet (15) en examen reçus de la première unité (31) d'antenne, au moyen du couplage inductif avec la deuxième unité (32) d'antenne.

13. Dispositif (10) de résonance magnétique suivant la revendication 12, comprenant une bobine (26) locale suivant la revendication 2, comportant en outre un dispositif (17) de couchette du patient, dans lequel l'élément (35) de maintien de la bobine (26) locale est assemblé mécaniquement au dispositif (17) de couchette du patient et dans lequel le dispositif (17) de couchette du patient et/ou l'élément (35) de maintien ont une unité (40) de mise en position, qui est constituée pour modifier une position relative et/ou l'orientation de la deuxième unité (32) d'antenne par rapport au dispositif (17) de couchette du patient.
